# EUROPEAN PATENT SPECIFICATION

(11) **EP 1 017 108 B1**
(45) Date of publication and mention of the grant of the patent: **18.02.2009**
(21) Application number: 99125839.3
(22) Date of filing: 23.12.1999
(51) Int. Cl.: H01L 29/51, C23C 14/06, H01L 21/28, H01L 29/786, C23C 14/00

(54) **Semiconductor devices and methods of manufacturing the same**
Halbleitervorrichtungen und deren Herstellung
Dispositifs semi-conducteurs et procédés de fabrication

(30) Priority: 25.12.1998 JP 37017098
(43) Date of publication of application: 05.07.2000
(73) Proprietor: SEMICONDUCTOR ENERGY LABORATORY CO., LTD., Atsugi-shi, Kanagawa-ken 243-0036 (JP)
(72) Inventor: Yamazaki, Shunpei, Atsugi-shi, Kanagawa-ken 243-0036 (JP)
(74) Representative: Grünecker, Kinkeldey, Stockmair & Schwanhäusser Anwaltssozietät

(56) References cited:
- EP-A- 0 394 054
- EP-A- 0 566 838
- EP-A- 0 999 595
- US-A- 4 990 365
- US-A- 5 232 862
- US-A- 5 324 690
- US-A- 5 756 250
- MASAHIKO MAEDA ET AL: "A LOW-PERMITTIVITY INTERCONNECTION USING AN SIBN INTERLAYER" IEEE TRANSACTIONS ON ELECTRON DEVICES,US,IEEE INC. NEW YORK, vol. 36, no. 9 - I, 1 September 1989 (1989-09-01), pages 1610-1614, XP000087124 ISSN: 0018-9383
- PATENT ABSTRACTS OF JAPAN vol. 014, no. 546 (E-1008), 4 December 1990 (1990-12-04) & JP 02 234438 A (CASIO COMPUT CO LTD), 17 September 1990 (1990-09-17)
- PATENT ABSTRACTS OF JAPAN vol. 017, no. 538 (E-1440), 28 September 1993 (1993-09-28) & JP 05 152328 A (CASIO COMPUT CO LTD), 18 June 1993 (1993-06-18)
- PATENT ABSTRACTS OF JAPAN vol. 017, no. 241 (E-1364), 14 May 1993 (1993-05-14) & JP 04 367277 A (NEC CORP), 18 December 1992 (1992-12-18)
- PATENT ABSTRACTS OF JAPAN vol. 012, no. 369 (E-665), 4 October 1988 (1988-10-04) & JP 63 120429 A (TOSHIBA CORP), 24 May 1988 (1988-05-24)
- PATENT ABSTRACTS OF JAPAN vol. 012, no. 353 (C-530), 21 September 1988 (1988-09-21) & JP 63 111173 A (ANELVA CORP;OTHERS: 01), 16 May 1988 (1988-05-16)
- PATENT ABSTRACTS OF JAPAN vol. 1996, no. 02, 29 February 1996 (1996-02-29) & JP 07 278790 A (A G TECHNOL KK), 24 October 1995 (1995-10-24)
- PATENT ABSTRACTS OF JAPAN vol. 015, no. 282 (C-0850), 17 July 1991 (1991-07-17) & JP 03 097846 A (KAO CORP), 23 April 1991 (1991-04-23)
- PATENT ABSTRACTS OF JAPAN vol. 014, no. 452 (P-1112), 27 September 1990 (1990-09-27) & JP 02 179947 A (RICOH CO LTD), 12 July 1990 (1990-07-12)
- PATENT ABSTRACTS OF JAPAN vol. 011, no. 396 (E-568), 24 December 1987 (1987-12-24) & JP 62 156822 A (NIPPON TELEGR & TELEPH CORP), 11 July 1987 (1987-07-11)
- PATENT ABSTRACTS OF JAPAN (E-1478), December 1993 (1993-12) & JP 52 035036 A (KYOCERA CORP), 10 September 1993 (1993-09-10)

## Description

### BACKGROUND OF THE INVENTION

### Technical Field

The present invention relates to a method of manufacturing semiconductor devices that use a crystalline semiconductor film formed by crystallizing amorphous semiconductor thin film, and more particularly to a method of improving the reliability of the semiconductor devices. The semiconductor devices of the present invention include not only such devices as thin film transistors (TFTs) and MOS transistors but also electro optical devices, such as displays and image sensors, that have semiconductor circuits constructed of these insulated gate transistors. In addition, the semiconductor devices include electronic apparatus mounting these displays and electro optical devices.

### Related Art

Recent years have seen a rapid advance in the technology for fabricating semiconductor circuits by forming TFTs on a glass substrate. Representative of these semiconductor circuits are electro optical devices such as active matrix liquid crystal displays.

The active matrix liquid crystal display is a monolithic display having a pixel matrix circuit and a driver circuit formed on the same substrate. Further, efforts are being made to develop a system-on-panel which also incorporates a logic circuit such as a memory circuit and a clock generation circuit.

The driver circuit and the logic circuit of the active matrix liquid crystal display must be operated at high speed, so it is not appropriate to use an amorphous silicon film as an active layer. Hence, at present a TFT that uses a polycrystalline silicon film as an active layer is becoming a mainstream.

Because the TFT can be formed on a transparent glass substrate, research has been promoted positively to apply the TFT to the active matrix liquid crystal display. The TFT using a polycrystalline silicon film provides a high mobility and thus makes it possible to realize a highly detailed image display by integrating a functional circuit on the same substrate.

As the resolution of the screen of the active matrix liquid crystal display becomes high, one million TFTs are required for pixels alone. When a functional circuit is added, a greater number of TFTs are required and it is necessary to secure the reliability of individual TFTs and make them operate stably in order to operate the liquid crystal display in a stable condition.

In such an active matrix liquid crystal display, when the TFTs are formed on a substrate with a poor thermal conductivity and a good heat retention (such as a glass substrate), large voltage and current are applied to the TFTs in a peripheral drive circuit, with the result that the semiconductor layer is heated to significantly degrade the reliability of the TFTs.

JP 04-367277 relates to a thin film transistor and the manufacturing thereof and discloses all of the features in the preamble of claims 1 and 14.

EP-A-0999595 is prior art according to Article 54(3) EPC and discloses a silicon nitride film doped with a fine amount of boron which is used as a protective film. This film is used as a base film on a glass substrate on which the TFT structure can be formed

The present invention has been accomplished with a view to overcoming the drawbacks mentioned above, and its objective is to provide a technology that can quickly scatter heat generated when the TFTs provided on an insulating surface are driven, and uniformly distributes heat over the entire semiconductor device.

### SUMMARY OF THE INVENTION

To solve the above problems, this invention is characterized in that an insulating film (SiBₓN_{y}: X>0, Y>0) excellent in thermal conductivity is formed as an insulating film of semiconductor elements or semiconductor devices by a sputtering method which can deposit a film at low temperature and has excellent productivity. The insulating film (SiBₓN_{y}) of the invention contains 0.1 to 50 atoms% or 1 to 50 atoms %, preferably 0.1 to 10 atoms%, of boron and thus has a high thermal conductivity, which in turn prevents characteristic deterioration due to heat of the semiconductor device. Further, the insulating film (SiBₓN_{y}) of this invention has an effect of blocking movable ions such as sodium and therefore prevents these ions from the substrate from infiltrating into the semiconductor device, particularly into the channel forming region.

A semiconductor device of the invention disclosed in this specification comprises the features set forth in claim 1 and 2.

A manufacturing method according to the invention comprises the features of claims 14 and 15.

### BRIEF DESCRIPTION OF THE DRAWINGS

Fig. 1A to Fig. 1E are explanatory views showing a process of manufacturing TFTs according to the embodiment 1.
Fig. 2A to Fig. 2D are explanatory views showing a process of manufacturing TFTs according to the embodiment 1.
Fig. 3A to Fig. 3C are explanatory views showing a process of manufacturing TFTs according to the embodiment 1.
Fig. 4A to Fig. 4F are explanatory views showing a process of manufacturing TFTs according to the embodiment 2.
Fig. 5A to Fig. 5D are explanatory views showing a process of manufacturing TFTs according to the embodiment 2.
Fig. 6A to Fig. 6D are explanatory views showing a process of manufacturing TFTs according to the embodiment 2.
Fig. 7A to Fig. 7C are a top view, a cross-sectional view and a schematic circuit diagram of a CMOS circuit according to the embodiment 3.
Fig. 8A and Fig. 8B are a top view and a cross-sectional view of a pixel matrix circuit according to the embodiment 3.
Fig. 9A to Fig. 9E are explanatory views showing a process of manufacturing TFTs according to the embodiment 4.
Fig. 10A to Fig. 10C are explanatory views and a top view showing a process of manufacturing TFTs according to the embodiment 4.
Fig. 11A and Fig. 11B are cross-sectional views of a substrate showing a crystallization process according to the embodiment 5.
Fig. 12A and Fig. 12B are cross-sectional views of a substrate showing a crystallization process according to the embodiment 5.
Fig. 13A and Fig. 13B are cross-sectional views of a substrate showing a gettering process according to the embodiment 6.
Fig. 14A and Fig. 14B are cross-sectional views of a substrate showing a gettering process according to the embodiment 7.
Fig. 15A and Fig. 15B are cross-sectional views of a substrate showing a gettering process according to the embodiment 8.
Fig. 16 is a cross-sectional view of a staggered TFT according to the embodiment 9.
Fig. 17 is a schematic diagram showing the configuration of an active matrix substrate.
Fig. 18 is a cross-sectional view of a bottom gate TFT according to the embodiment 12.
Fig. 19A to Fig. 19F are explanatory views of electronic equipment.
Fig. 20A to Fig. 20D are explanatory views of electronic equipment.
Fig. 21A to Fig. 21C are explanatory views of electronic equipment.
Fig. 22A and Fig. 22B are a top view and a cross-sectional view of an EL display.
Fig. 23A and Fig. 23B are a top view and a cross-sectional view of an EL display.
Fig. 24 is a cross-sectional view of a pixel portion of an EL display.
Fig. 25A and Fig. 25B are a top view and a circuit diagram of a pixel portion of an EL display.
Fig. 26 is a cross-sectional view of a pixel portion of an EL display.
Fig. 27A to Fig. 27C are circuit diagrams of pixel portions of an EL display.

### DETAILED DESCRIPTION OF THE INVENTION

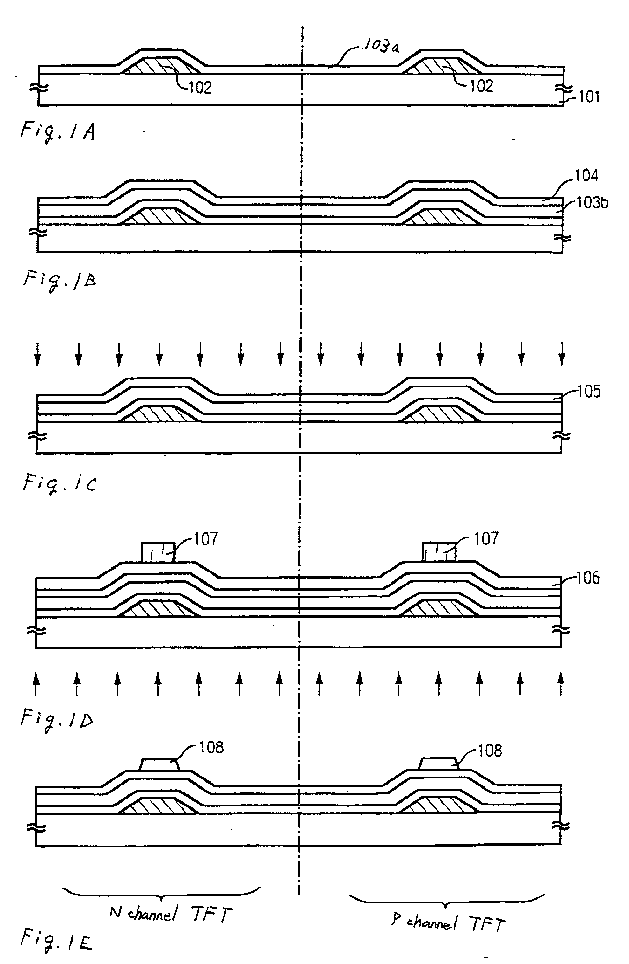

Referring to Figs. 1A to 1E, an embodiment of the invention will be described. Here we take up as an example a bottom-gate TFT having a gate insulating film comprising an insulating film (SiBₓN_{y}) formed by sputtering and a method of manufacturing the bottom-gate TFT.

First, a substrate 101 is prepared. The substrate 101 may be an insulating substrate such as a glass substrate, a quartz substrate and a crystalline glass, a ceramic substrate, a semiconductor substrate, and a plastic substrate (polyethylene terephthalate substrate).

Next, a conductive film made of a conductive material sputtered on the substrate 101 is patterned to form a gate line (including a gate electrode) 102. As for the material of the gate line 102, there is no special limitation, except that the gate line needs only to have at least one layer of a material that contains a conductive or semiconductormaterial as a main component: for example, a metal such as Ta (tantalum), Mo (molybdenum), Ti (titanium), W (tungsten) and Cr (chromium), silicide or a compound of these metals and silicon, polycrystalline silicon comprising N or P type conductivity, and a low resistance metal such as Cu (copper) and Al (aluminum).

Next, a silicon nitride film (SiBₓN_{y}) 103a is sputtered on the substrate 101 and the gate line 102.

A sputtering apparatus used in the embodiment of this invention basically comprises a chamber, an exhaust system to evacuate the chamber, a gas introducing system for introducing a sputter gas into the chamber, an electrode system having a target and an RF electrode, and a sputtering power supply connected to the electrode system. The gas used for sputtering is one or more kinds of inert gases selected from Ar, He, Ne and N₂. The condition of sputtering (such as the kind of gas for sputtering, gas flow rate, film forming pressure, substrate temperature, and film forming electric power) may be determined by a practitioner as required, considering the size of a target, the dimension of the substrate, the thickness of silicon nitride film (SiBₓN_{y}), and the quality of silicon nitride film (SiBₓN_{y}). It is also possible to use DC power instead of RF power.

One of the features of this invention is the method of forming the silicon nitride film (SiBₓN_{y}) 103a and there are two such methods as shown below.

A first method of forming the silicon nitride film is a sputtering method using a target, which is a single crystal silicon doped with boron, in an atmosphere comprising nitrogen (N₂) or ammonia (NH₃). The target used in this invention is preferably a single crystal or polycrystalline semiconductor target containing 1x10¹⁷ cm⁻³ or more of boron. By changing the boron content in the target the composition ratio of the boron in the silicon nitride film (SiBₓN_{y}) 103a can be changed. It is also possible to obtain an insulating film with a more complicated composition ratio by using a plurality of different targets at the same time, such as a target doped with boron and a target doped with a different impurity (such as gallium) that gives one conductivity type.

A second forming method according to this invention is a sputtering method using a target of a single crystal silicon in an atmosphere comprising an inert gas (for example, argon) and a gas containing boron (for example, diborane (B₂H₆)). Changing the amount of boron-containing gas can change the composition ratio of the insulating film (SiBₓN_{y}) composed mainly of silicon nitride. The boron content in the atmosphere may be changed continuously or stepwise to produce a density gradient of boron in the film.

With the use of the first or second forming method described above, it is possible to form the silicon nitride film (SiBₓN_{y}) 103a that contains 0.1 to 50 atoms% or 1 to 50 atoms%, preferably 0.1 to 10 atoms%, of boron in the film and has a high thermal conductivity. The silicon nitride film (SiBₓN_{y}) 103a, because it contains boron, has a higher thermal conductivity than that of the conventional silicon nitride (SiN). The silicon nitride film (SiBₓN_{y}) of course has a sufficient insulating performance. By forming the silicon nitride film (SiBₓN_{y}) in contact with the gate electrode, in particular, the heat generated when driving the TFT can be dispersed quickly, which facilitates uniform distribution of heat over the entire semiconductor device.

Next, an insulating film 103b and an amorphous semiconductor film 104 are successively formed in stacking layers without exposing them to an open air (Fig. 1B). In this way the interface contamination can be prevented. Although the two layers of the insulating film 103a and the insulating film 103b are used as a gate insulating film, the gate insulating film may be formed as a single-layered structure or three or more-layered structure.

The amorphous semiconductor film 104 may be an amorphous semiconductor film comprising silicon, such as an amorphous silicon film, an amorphous semiconductor film having microcrystals, a microcrystalline silicon film, an amorphous germanium film, an amorphous silicon germanium film represented by SiₓGe₁₋ₓ (0<X<1), or a laminated film of these 10 to 80 nm thick, more preferably 15 to 60 nm thick. A possible means for forming the insulating film 103b and the amorphous semiconductor film 104 includes a thermal CVD, a plasma CVD, a low pressure CVD, a vacuum evaporation, and a sputtering.

Next, the amorphous semiconductor film 104 is crystallized to form a crystalline semiconductor film 105 (Fig. 1C). The crystallization processing may include any known means, such as thermal crystallization processing, crystallization processing using infrared laser or ultraviolet laser radiation, thermal crystallization processing using a catalytic element, or a combination of these.

By using the crystalline semiconductor film 105 thus formed as an active layer, a bottom-gate TFT is manufactured. While the crystalline semiconductor film 105 is used as an active layer, it is possible not to perform the crystallization process but to use the amorphous semiconductor film as an active layer in fabricating the bottom-gate TFT. The subsequent processes are not detailed here because they can be performed according to a known manufacturing method.

This example has shown a case where the insulating film (SiBₓN_{y}) containing 0.1 to 50 atoms% or 1 to 50 atoms%, preferably 0.1 to 10 atoms%, of boron and having a high thermal conductivity is used as one layer of the gate insulating film of the bottom-gate TFT. This may also be used as other insulating films, such as a base film (an underlying film), an interlayer insulating film, a mask insulating film, a channel protection film and a passivation film. Further, it can also be used as the insulating film of the top-gate TFT, such as a base film, a gate insulating film, a mask insulating film, an interlayer insulating film and a passivation film. It can also be applied to the insulating films of a staggered TFT. In this way, the application of the invention does not depend on the TFT structure.

Therefore, the semiconductor device using as an insulating film the silicon nitride film (SiBₓN_{y}) containing 0.1 to 50 atoms% or 1 to 50 atoms%, preferably 0.1 to 10 atoms%, of boron and having high thermal conductivity can quickly disperse the heat generated when driving the TFT thereby uniformly distributing the heat over the entire semiconductor device.

In the following, embodiments of the invention will be described. It should be noted, however, that the invention is not limited to these embodiments.

### [Embodiment 1]

The first embodiment of the invention will be detailed by referring to Figs. 1A to 1E, 2A to 2D and 3A to 3C.

First, a glass substrate (Corning 1737: distortion point at 667°C) is prepared as the substrate 101. Then, on the substrate 101 is formed a gate line (including gate electrode) 102 of a laminated structure (not shown for simplification). In this embodiment, a tantalum nitride film (50 nm thick) and a tantalum film (250 nm thick) are formed in laminated layers by sputtering and then the laminated layers are patterned by a known photolithography method to form a gate line (including gate electrode) 102 having a laminated structure.

Next, a silicon nitride film containing boron (SiBₓN_{y}) 103a is formed to a thickness of 1 to 1000 nm, preferably 10 to 100 nm, by sputtering (Fig. 1A). In this embodiment, a target of a single crystal silicon doped with boron was sputtered in an atmosphere comprising nitrogen (N₂) or ammonia (NH₃) to form the silicon nitride film (SiBₓN_{y}) 50 nm thick. It is also possible to form the silicon nitride film (SiBₓN_{y}) by sputtering using a single crystal silicon target in an atmosphere of argon and diborane (B₂H₆). The silicon nitride film (SiBₓN_{y}) thus obtained contains 0.1 to 50 atoms% or 1 to 50 atoms%, preferably 0.1 to 10 atoms%, of boron and therefore has a high thermal conductivity, which in turn produces an effect of preventing characteristic degradation due to heat of the semiconductor device. Further, because the silicon nitride film exhibits an ability to block moving ions such as sodium, it can prevent these ions from the substrate from infiltrating into the semiconductor device, particularly into the channel forming region.

Next, an insulating film 103b and an amorphous semiconductor film 104 are formed in laminated layers without being exposed to an open air (Fig. 1B). In this embodiment, the silicon oxide film 103b (125 nm thick) was formed on the first insulating layer by the plasma CVD method to form the gate insulating film of a laminated structure. Although this embodiment uses two layers of insulating film as the gate insulating film, the gate insulating film may be a single-layered or three or more-layered structure. In this embodiment an amorphous silicon film 54 nm thick was formed as an amorphous semiconductor film 104 on the gate insulating film by the plasma CVD method. To prevent the interfaces of these layers from becoming attached with contaminants from the open air, these layers were not exposed to the open air when they were successively formed in layers. Then, the device was heated (at 500°C for 1 hour) to reduce the hydrogen concentration in the amorphous silicon film that hinders crystallization of the semiconductor film.

After the state of Fig 1B is obtained, the amorphous semiconductor film 104 was irradiated with an infrared or ultraviolet radiation for crystallization (laser crystallization) to form a crystalline semiconductor film or a semiconductor film including crystals 105 (Fig. 1C). When an ultraviolet beam is to be used for crystallization, an excimer laser beam or a strong beam from an ultraviolet lamp may be used. When an infrared beam is to be used, an infrared laser beam or a strong beam from an infrared lamp may be used. This embodiment used a KrF excimer laser beam by forming it into a linear shape. The radiation conditions include a pulse frequency of 30 Hz, an overlap rate of 96%, and a laser energy density of 100 to 500 mJ/cm². This embodiment adopted the laser energy density at 360 mJ/cm². The conditions of laser crystallization (wavelength of the laser beam, overlap rate, radiation intensity, pulse width, repetition frequency, irradiation time, etc.) can be determined as required by a practitioner considering the thickness of the amorphous semiconductor film 104, the substrate temperature and others. Depending on the conditions of laser crystallization, there are cases where the initial semiconductor film passes through the melted state before being crystallized, and where the initial semiconductor film does not melt but crystallizes from a solid state or from an intermediate state between the solid state and the liquid state. During this process the amorphous semiconductor film 104 is crystallized and changes into the crystalline semiconductor film 105. In this embodiment, the crystalline semiconductor film 105 is a polycrystalline silicon film.

Next, on the crystalline semiconductor film 105 thus obtained is formed an insulating film 106 which will later be a channel protection film that will protect the channel forming region. In this embodiment, a silicon oxide (200 nm thick) was formed. Then, by the patterning using the exposure light from the back, a resist mask 107 was formed in contact with the insulating film 106 (Fig. 1D). The patterning includes forming, exposure and development of a resist mask. Because a mask is not required in forming a resist mask by using an exposure light from the back, the number of fabrication masks can be reduced. As shown in the figure, the size of the resist mask was slightly smaller than the width of the gate line 102 because of the wraparound of light.

Next, with the resist mask 107 as a mask, the insulating film 106 was etched to form a channel protection film 108, after which the resist mask 107 was removed (Fig. 1E). This process exposes the surface of the polycrystalline silicon film in areas other than those where it is in contact with the channel protection film 108. The channel protection film 108 serves to prevent a dopant from being added to regions that will become channel forming regions in the later doping process. While this embodiment uses a silicon oxide film as the channel protection film 108, it is possible to use, instead of the silicon oxide film, a silicon nitride film containing boron (SiBₓN_{y}) according to this invention to form a structure that prevents characteristic degradation due to heat of the semiconductor device.

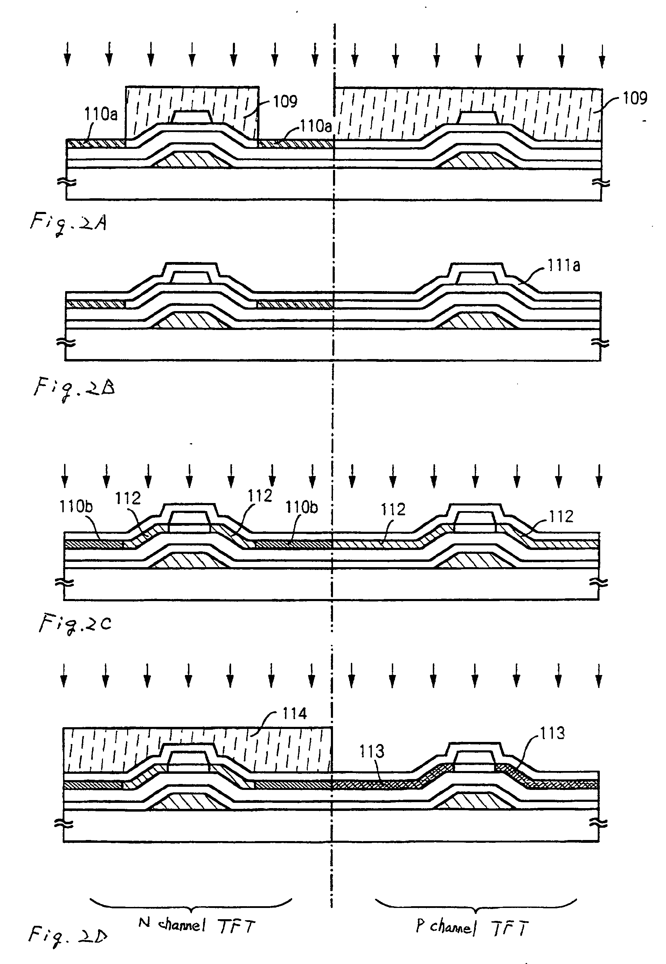

Next, the wafer was patterned using a photo mask to form a resist mask 109 covering a part of an n channel TFT or covering ap channel TFT, and an impurity that gives an n type conductivity was added to the exposed crystalline semiconductor film to form a first impurity region (n⁺ region) 110a (Fig. 2A). In this embodiment phosphorus was used as an impurity to give an n type conductivity. Phosphine (PH₃) diluted to 1 to 10% (in this embodiment, 5%) with hydrogen was used as a doping gas, and the amount of dose was set at 5x10¹⁴ atoms/cm² and the accelerating voltage at 10 kV. By properly setting the pattern of the resist mask 109, the implementer can relatively easily determine the width of the n⁺ type region and thereby obtain an n⁻ type region and a channel forming region of desired widths.

After the resist mask 109 was removed, an insulating film 111a for forming an LDD region was formed (Fig. 2B). In this embodiment, a silicon oxide film (50 nm thick) was formed as the insulating film 111a by the plasma CVD method. While this embodiment uses the silicon oxide film as the insulating film 111a, it is possible to use a silicon nitride film containing boron (SiBₓN_{y}) of this invention instead of the silicon oxide film in order to produce a structure that prevents characteristic degradation due to heat of the semiconductor device.

Next, an impurity for giving an n type conductivity is added to the crystalline semiconductor film covered at the surface with the insulating film 111a to form a second impurity region (n⁻ region) 112 (Fig. 2C). It is important that the thickness of the insulating film 111a be considered in setting the doping condition for adding the impurity through the insulating film 111a into the underlying crystalline semiconductor film. In this embodiment phosphine diluted to 1 to 10% (in this embodiment, 5%) with hydrogen gas was used as a doping gas, and the amount of dose was set at 3x10¹³ atoms/cm² and the accelerating voltage at 60 kV. Doping an impurity through this insulating film 111a resulted in the formation of an impurity region with a desired impurity concentration (1x10¹⁸ to 1x10¹⁹ atoms/cm³ by SIMS analysis). The second impurity region 112 thus formed functions as an LDD region. At this time, an impurity is further added to form a first impurity region 110b, leaving an intrinsic crystalline semiconductor region just under the channel protection film. Though not shown, the impurity is actually doped slightly inside the channel protection film.

Next, a resist mask 114 covering the n-channel TFT is formed by using a photo mask, and an impurity to give a p type conductivity is added to the crystalline semiconductor film to form a third impurity region (p⁺ region) 113 (Fig. 2D). In this embodiment boron (B) was used as an impurity that gives the p type conductivity. Diborane (B₂H₆) diluted to 1 to 10% with hydrogen was used as a doping gas, and the amount of dose was set at 4x10¹⁵ atoms/cm² and the acceleration voltage at 30 kV.

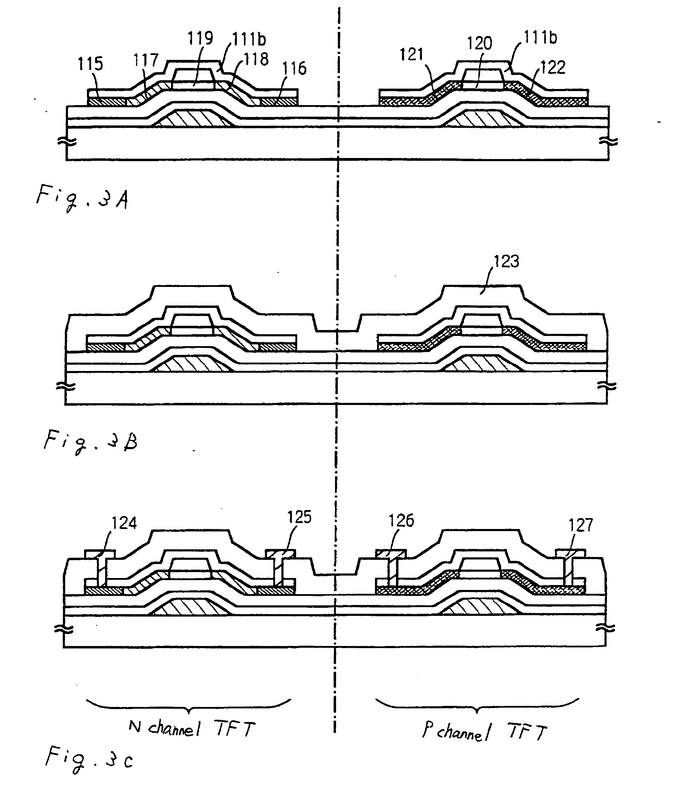

Then, after the resist mask 114 was removed and the impurity was activated by the laser anneal or thermal anneal, a heat treatment was performed (at 350°C for 1 hour) in the presence of hydrogen to hydrogenate the entire device. Then, it was patterned by a known technique to form an active layer with a desired shape (Fig. 3A). At this time, the insulating film 111a covering the active layer was also patterned to form an insulating film 111b.

With the above processes completed, a source region 115, a drain region 116, low-concentration impurity regions 117, 118 and a channel forming region 119 of the n channel TFT were formed, and a source region 121, a drain region 122 and a channel forming region 120 of the p channel TFT were formed.

Next, an interlayer insulating film 123 covering the n channel TFT and the p channel TFT was formed in a laminated structure consisting of a silicon oxide film 100 nm thick formed by the plasma CVD method and a silicon oxide film 940 nm thick formed by using a source gas of TEOS and oxygen (Fig. 3B). While this embodiment uses a silicon oxide film as the interlayer insulating film 123, it is possible to use a boron-containing silicon nitride film (SiBₓN_{y}) of this invention in stead of the silicon oxide film to provide a structure that prevents characteristic degradation due to heat of the semiconductor device.

Then, contact holes were formed to form source lines 124, 126 and drain lines 125, 127, thus realizing the state shown in Fig. 3C. Finally, the device was heat-treated in a hydrogen atmosphere to hydrogenate the entire device, thus completing the n channel TFT and a p channel TFT.

In this embodiment the sequence of processes may be changed to perform the crystallization after the patterning of the amorphous semiconductor film. The sequence of adding the impurity is not limited to the one adopted in this embodiment, and the implementer may change the impurity doping sequence as necessary to form the impurity regions.

### [Embodiment 2]

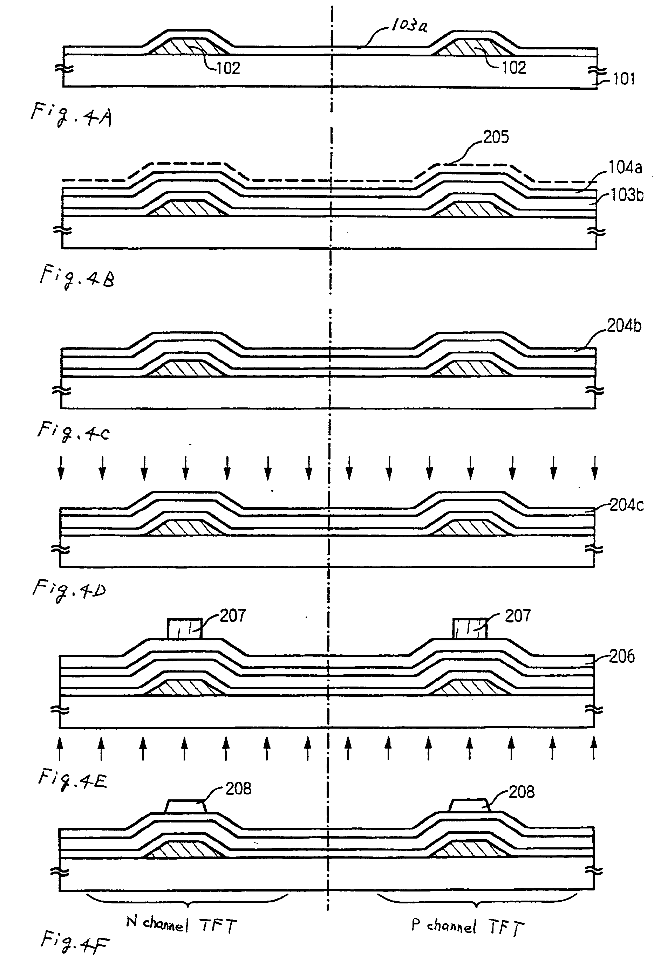

While the embodiment 1 crystallizes the amorphous silicon film by the laser beam, this embodiment shows an example process of crystallizing the amorphous semiconductor film in a manner different from the embodiment 1. This embodiment will be described by referring to Figs. 4A to 4F, 5A to 5D and 6A to 6D.

First, as in the embodiment 1, a gate line 102 and gate insulating films 103a, 103b were formed on the substrate 101 (Fig. 4A). The process up to this point is the same as the embodiment 1 and the components identical to those of the embodiment 1 are given like reference numbers. The gate insulating film 103a is a silicon nitride film containing boron (SiBₓN_{y}).

Next, an amorphous silicon film 104a is formed according to the embodiment 1. Then, in an oxygen atmosphere the amorphous silicon film 104a is irradiated with ultraviolet radiation to formavery thin oxide filmnot shown on its surface. This oxide film has a function of improving the wettability of a solution containing nickel which is to be applied later to the amorphous silicon film 104a.

Then, the solution containing nickel is applied to the surface of the amorphous silicon film 104a. The content of nickel should be in the range of 0.1 to 50 ppm (by weight), more preferably 1 to 30 ppm. This range is chosen to set the nickel concentration in the amorphous silicon film 104a at a level on the order of 10¹⁵ to 10¹⁹ atoms/cm³. The nickel concentration less than 10¹⁵ atoms/cm³ cannot produce the catalytic action of nickel. At the concentration of about 10¹⁹ atoms/cm³, it is possible to manufacture the TFT that is operable even when the gettering is not performed and the gettering process can be carried out efficiently. The nickel concentrations described above are defined by the maximum values of measurements by SIMS.

In this embodiment, a nickel acetate solution containing 10 ppm of nickel is applied. Then, the substrate 101 is rotated by a spin coater in order to throw away an excess nickel acetate solution. And a very thin nickel-containing layer 205 is formed on the surface of the amorphous silicon film 104a (Fig. 4B).

When the state of Fig. 4B is obtained, the wafer is heated at 550°C for four hours in a nitrogen atmosphere to crystallize the amorphous silicon film 104a. This crystallization process forms a polycrystalline silicon film 204b. The crystal growth propagates in a vertical direction toward the substrate 101 from the surface of the amorphous silicon film 104a to which the nickel was applied. This crystal growth is called a vertical growth in this specification (Fig. 4C). While this embodiment forms the nickel-containing layer on the entire surface of the wafer, it is possible to selectively form the nickel-containing layer by using a resist to propagate the crystallization in a direction parallel to the substrate surface (in a horizontal direction).

Although this crystallization process forms a polycrystalline silicon film containing grain boundaries, it is possible to form a silicon film in a microcrystalline state under different conditions.

The above heating process can be done at temperatures of 500 to 700°C, more preferably 550 to 650°C, in an electric furnace. At this time, the upper limit of the heating temperature must be set lower than the distortion point of the glass substrate 101 used, considering the heat resistance. At temperatures in excess of the distortion point of glass, the warping and contraction of the glass substrate become conspicuous. The heating time may be set at 1 to 12 hours. This heating process is done by the furnace anneal (heating in an electric furnace). Other heating means such as lamp anneal may also be employed.

Next, the polycrystalline silicon film 204b thus obtained is applied with a laser beam to form a polycrystalline silicon film 204c with an improved crystallinity. In this embodiment, a pulse oscillation type KrF excimer laser of which wavelength is 248 nm was used (Fig. 4D). Before applying the laser beam, the very thin oxide film for improving the wettability of the solution may be removed.

As a pulse oscillation type laser, a XeCl excimer laser of short wavelength (in an ultraviolet region) and a YAG laser of long wavelength may be used. Because the excimer laser used in this embodiment oscillates an ultraviolet beam, the melting and solidifying are repeated instantaneously in the irradiated areas. Hence, by applying the excimer laser beam, a kind of imbalanced state is formed where nickel can move easily.

In the polycrystalline silicon film 204b formed in the crystallization process of Fig. 4C, amorphous components remain in an irregular manner. But the application of the laser beam as shown in Fig. 4D can completely crystallize the amorphous components, so the crystallinity of the polycrystalline silicon film 204c is significantly improved.

Although this laser irradiation process may be omitted, the application of the laser provides the effect of improving the efficiency of the gettering process to be performed later, in addition to improving the crystallinity. After the laser irradiation, the maximum SIMS value of the residual nickel concentration in the polycrystalline silicon film 204c is around 1x10¹⁹ to 2x10¹⁹ atoms /cm³.

After the crystallization process, it is possible to use a gettering technique that removes or reduces the amount of catalytic elements remaining in the polycrystalline silicon film described in JP-A 10-270363 official gazette corresponding to a U.S. Patent Application Serial No. 09/050,182 (later-published patent US 6893503). This official gazette discloses a technique of heating the wafer (at 300 to 700°C for 1 to 12 hours) after doping the entire area or selected areas with phosphorus. Further, it is also possible to use a liquid phase method using hot sulfuric acid, a gas phase method using a gas containing halogen elements, and a method of heating by adding boron.

Next, as in the process shown in Fig. 1D of the embodiment 1, an insulating film 206 which is 200 nm thick for protecting the channel forming region which will later be a channel protection film is formed on the polycrystalline silicon film 204c. While this embodiment uses a silicon oxide film as the insulating film 206, a silicon nitride film containing boron (SiBₓN_{y}) according to this invention may be used instead of the silicon oxide film to form a structure that prevents characteristic deterioration due to heat of the semiconductor device. Next, a resist mask 207 is formed in contact with the insulating film 206 by the patterning using an exposure light from the back (Fig. 4E).

Then, with the resist mask 207 as a mask, the insulating film 206 is etched away to form a channel protection film 208. After this, the resist mask 207 is removed (Fig. 4F).

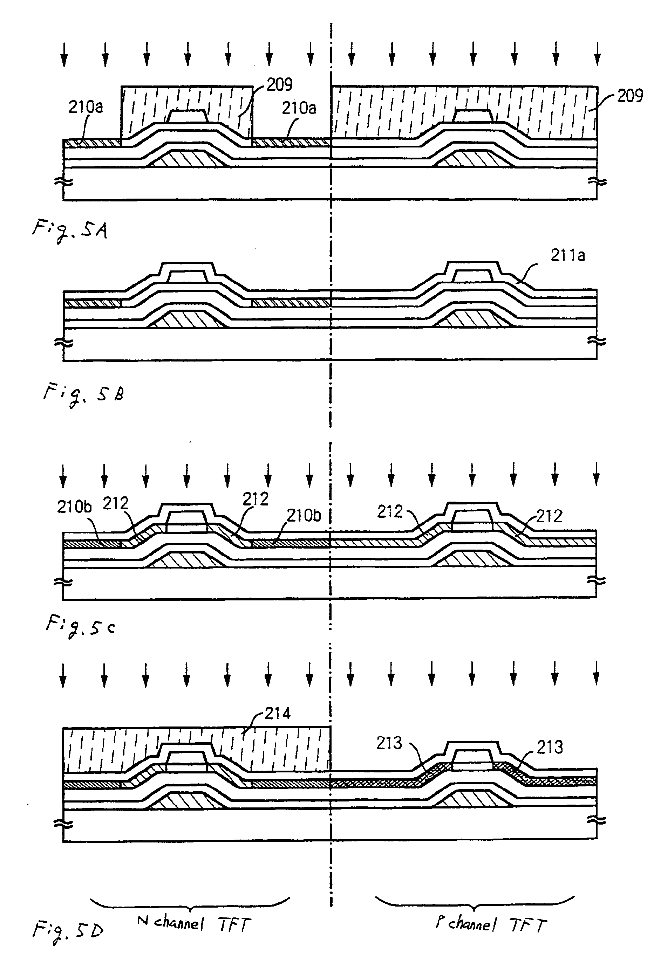

Then, by the patterning using a photo mask, a resist mask 209 covering a part of the n channel TFT or covering the p channel TFT is formed. An impurity (phosphorus) that gives an n type conductivity is added to the exposed surface of the crystalline semiconductor film to form a first impurity region (n⁺ region) 210a (Fig. 5A). In this embodiment, phosphine (PH₃) diluted to 1-10% (in this embodiment, 5%) with hydrogen was used as a doping gas, and the amount of dose was set at 5x10¹⁴ atoms/cm² and the accelerating voltage at 10 kV.

Next, after the resist mask 209 was removed, a control insulating film (in this embodiment, a silicon oxide film 50 nm thick) 211a to form an LDD region is formed (Fig. 5B). While this embodiment uses the silicon oxide film as the control insulating film 211a, a silicon nitride film containing boron (SiBₓN_{y}) according to this invention may be used instead of the silicon oxide film to form a structure that prevents characteristic degradation due to heat of the semiconductor device.

Next, an impurity that gives an n type conductivity is implanted into the crystalline semiconductor film covered at its surface with the control insulating film 211a to form a second impurity region (n⁻ region) 212 (Fig. 5C). In this embodiment, phosphine diluted to 1 to 10% (in this embodiment, 5%) with hydrogen was used as a doping gas, and the amount of dose was set at 3x10¹³ atoms/cm² and the accelerating voltage at 60 kV. By implanting the impurity element through the control insulating film 211a, an impurity region with a desired concentration (1x10¹⁸ to 1x10¹⁹ atoms/cm³ by SIMS analysis) was formed. The second impurity region 212 thus formed functions as an LDD region. At this time the impurity was further added to form a first impurity region 210b and an intrinsic crystalline semiconductor region remained just under the channel protection film.

Next, a resist mask 214 covering the n-channel TFT is formed by using a photo mask and an impurity element that gives a p type conductivity is added to the crystalline semiconductor film to form a third impurity region (p⁺ region) 213 (Fig. 5D). In this embodiment, diborane (B₂H₆) diluted to 1 to 10% (in this embodiment, 5%) with hydrogen was used as a doping gas, and the amount of dose was set at 4x10¹⁵ atoms/cm² and the accelerating voltage at 30 kV.

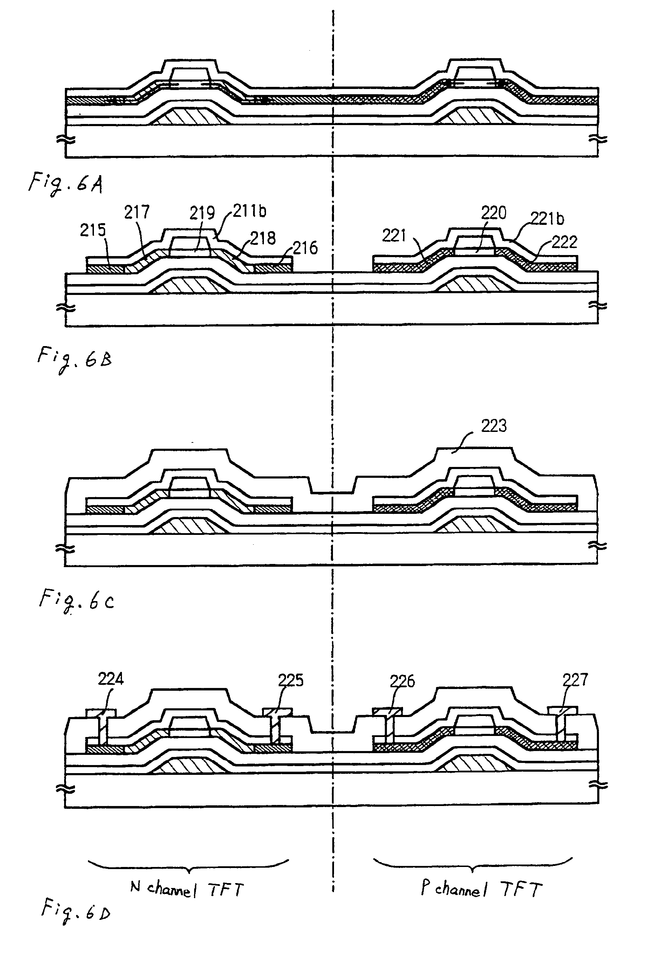

Next, the resist mask 214 is removed and a heat treatment is performed at 300 to 700°C for 1 through 12 hours. Then, a technology for reducing the nickel concentration described in JP-A 8-330602 official gazette is applied to this embodiment. The JP-A 8-330602 corresponds to U.S. Patent Applications Serial No. 08/928,740 and Serial No. 08/928,750 (respectively later-published patents US 6251712 and US 6518102). In this embodiment, a heat treatment was performed at 600°C for 8 hours to move the nickel remaining in the LDD region and in the channel forming region into the high concentration impurity region (source and drain regions) (Fig. 6A). In this way, a channel forming region with a reduced nickel concentration (1x10¹⁸ atoms/cm³ or lower, preferably 1x10¹⁶ atoms/cm³ or lower by SIMS analysis) is obtained. At the same time that the concentration of the catalytic element is reduced by the heating, the crystallinity damaged during doping is recovered and the impurity is activated by thermal anneal. In addition to this process, the furnace anneal, the laser anneal or the lamp anneal may be performed. After this, a heat treatment is performed at 350°C for 1 hour in a hydrogen atmosphere.

Then, a known patterning technique is used to form an active layer having a desired shape (Fig. 6B). At this time, the insulating film 211a covering the active layer is also patterned to form an insulating film 211b.

With the above process completed, a source region 215, a drain region 216 and low-concentration impurity regions 217, 218 and a channel forming region 219 of the n channel TFT are formed. A source region 221, a drain region 222 and a channel forming region 220 of the p channel TFT are also formed.

Next, an interlayer insulating film 223 covering the n channel TFT and the p channel TFT is formed in a laminated structure consisting of a silicon oxide film 100 nm thick formed by the plasma CVD method and a silicon oxide film 940 nm thick formed by using a source gas of TEOS and oxygen (Fig. 6C). While this embodiment uses a silicon oxide film as the interlayer insulating film 223, it is possible to use a silicon nitride film containing boron (SiBₓN_{y}) of this invention instead of the silicon oxide film to provide a structure that prevents characteristic degradation due to heat of the semiconductor device.

Then, contact holes are formed to form source lines 224, 226 and drain lines 225, 227, thus realizing the state shown in Fig. 6D. Finally, the heat treatment is performed in a hydrogen atmosphere to hydrogenate the entire device, thus completing the n channel TFT and a p channel TFT.

### [Embodiment 3]

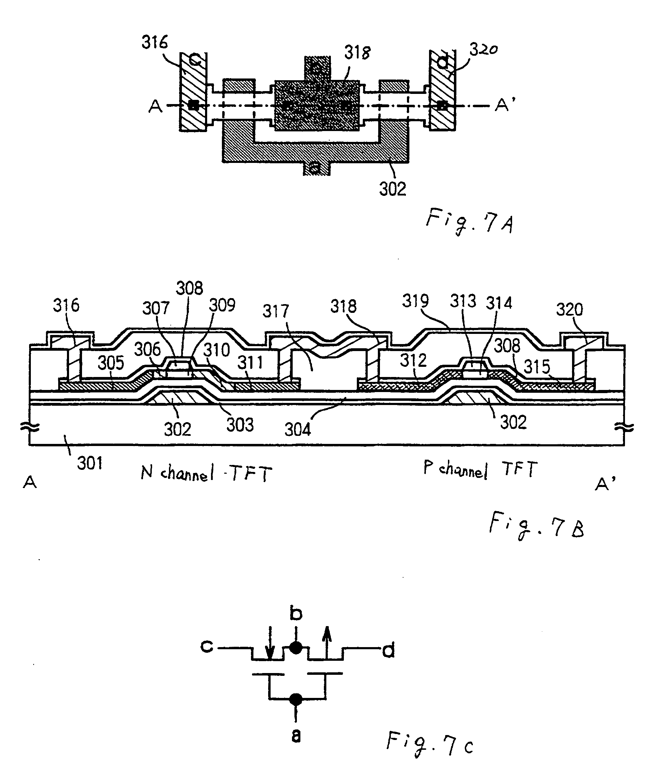

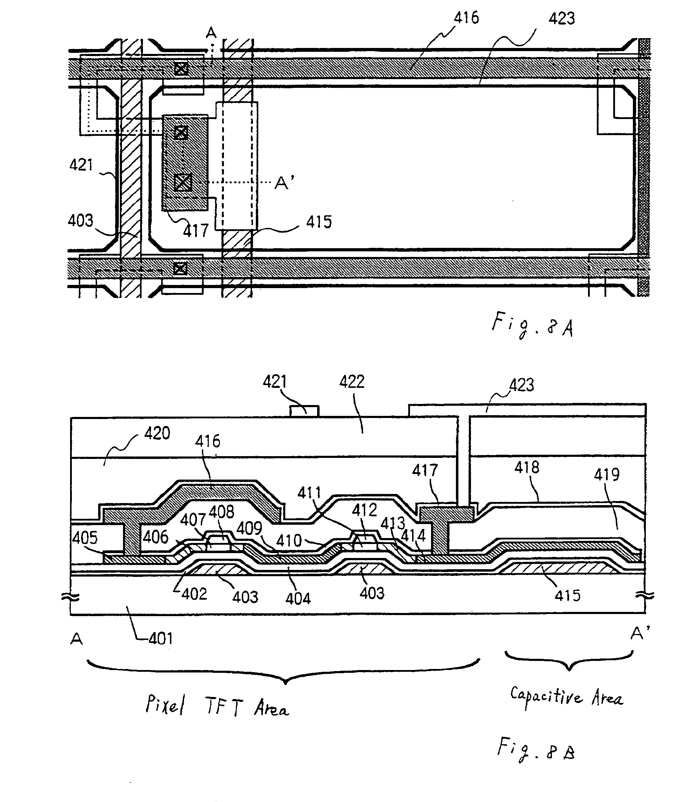

An example structure of a semiconductor device having an n channel TFT and a p channel TFT formed by using the manufacturing processes of the embodiment 1 or embodiment 2 will be described by referring to Figs. 7A to 7C, Figs. 8A and 8B.

The semiconductor device according to this invention has the peripheral drive circuit and the pixel matrix circuit on the same substrate. In this embodiment, a CMOS circuit forming a part of the peripheral drive circuit is shown in Figs. 7A to 7C and a pixel TFT (N channel TFT) forming a part of the pixel matrix circuit is shown in Figs. 8A and 8B to make illustrations simple. In addition to the manufacturing processes of the embodiment 1 and embodiment 2, a passivation film (protection film) 319 0.2 to 0.4 µm thick is formed. The passivation film 319 may be formed of a silicon nitride film, for example a silicon nitride film containing boron (SiBₓN_{y}), to provide a structure that prevents characteristic degradation due to heat of the semiconductor device.

The CMOS circuit shown in Figs. 7A to 7C is also called an inverter circuit and is a basic circuit forming a semiconductor circuit. By combining such inverter circuits, it is possible to form basic logic circuits, such as NAND circuit and NOR circuit, and more complex logic circuits.

Fig. 7A is a top view of Fig. 7B. In Fig. 7A. a portion cut along the dashed line A-A' corresponds to the cross-sectional structure of the CMOS circuit shown in Fig. 7B. Fig. 7C is a circuit diagram of the inverter circuit corresponding to Fig. 7A and Fig. 7B.

In Fig. 7B, both of the TFTs (thin-film transistors) are formed on the substrate 301. A P channel TFT of the CMOS circuit has a gate electrode 302, on which are laid a first insulating film 303 made of silicon nitride containing boron (SiBₓN_{y}) and a second insulating film 304 made of silicon oxide. On the second insulating film are formed p⁺ regions 312 (drain region), 315 (source region) and a channel forming regions 314 as active layers. Although in the embodiment 1 and the embodiment 2, a low-concentration impurity region (LDD region) is not provided in the P channel TFT between the high-concentration impurity region and the channel forming region in order to reduce the number of processes, it may be manufactured. The channel forming region 314 is protected by an insulating film 313. The p⁺ regions 312, 315 are protected by an insulating film (control insulating film) 308 having the same patterning shape as the active layer. Contact holes are formed in a first interlayer insulating film 317 that covers the insulating film 308. Connected to the p⁺ regions 312, 315 are wires 318, 320, on which a passivation film 319 is formed. Though not shown for simplicity, a second interlayer insulating film is formed on the passivation film 319 and a leadout wire is connected to the wire 320. On the leadout wire a third interlayer insulating film (not shown) is formed.

The N channel TFT has, as active layers, an n⁺ region (source region) 305, an n⁺ region (drain region) 311, a channel forming region 309, and n⁻ regions 306, 310 between the n⁺ region and the channel forming region. The n⁻ region 310 in contact with the drain region is formed wider than the n⁻ region 306 to improve the reliability. Contact holes are formed in the first interlayer insulating film 317 that covers the insulating film 308. Connected to the n⁺ regions 305, 311 are wires 316, 318, on which a passivation film 319 is formed. Though not shown for simplicity, a second interlayer insulating film is formed on the passivation film 319 and a leadout wire is connected to the wire 320. On the leadout wire a third interlayer insulating film is formed. Parts other than the active layers have almost the same structure as the P channel TFT and their explanation is omitted for simplicity. Denoted 307 is an insulating film with the same function as the insulating film.

Fig. 8A is a top view of Fig. 8B. In Fig. 8A the portion cut along the dotted line A-A' correspond to the cross-sectional structure of the pixel matrix circuit of Fig. 8B

The N channel TFT formed in the pixel matrix circuit is basically the same in structure as the N channel TFT in the CMOS circuit. On the substrate 401 are formed gate electrodes 403, on which are laid a first insulating film 402 made of silicon nitride film containing boron (SiBₓN_{y}) and a second insulating film 404 made of silicon oxide. On the second insulating film are formed, as active layers, n⁺ regions 405, 409, 414, channel forming regions 407, 411, and n⁻ regions 406, 413 between the n⁺ regions and the channel forming regions. The channel forming regions 407, 411 are protected by insulating films 408, 412, respectively. The n⁻ regions and n⁺ regions are protected by an insulating film (control insulating film) 410 that has the same patterning shape as the active layers. A first interlayer insulating film 419 covering the insulating film 410 is formed with contact holes, through which the n⁺ region 405 and n⁺ region 414 are connected to a wire 416 and a wire 417, respectively, on which a passivation film 418 is formed. On the passivation film 418 are formed a second interlayer insulating film 420 and a third interlayer insulating film 422 successively. Through these second and third interlayer insulating films, a pixel electrode 423 formed of a transparent conductive film such as ITO and SnO₂ is connected. Denoted 421 is a pixel electrode adjacent to the pixel electrode 423.

The capacitive area of the pixel matrix circuit is formed by a capacitive wire 415 and an n⁺ region 414 with the first and second insulating films as dielectrics.

While in this embodiment a transmission type LCD is manufactured as an example, it is possible to manufacture a reflection type LCD by using a metal material with reflectivity as a material of the pixel electrode and changing the patterning of the pixel electrodes, or by adding or eliminating some processes as required.

In this embodiment the gate line of the pixel TFT in the pixel matrix circuit is formed in a double gate structure. To reduce variations in the off-state current, the gate line may be formed in a multi gate structure such as a triple gate structure. Further, to improve an aperture ratio, it may be formed in a single gate structure.

The TFT manufactured in this embodiment exhibits electric characteristics with smaller variations. It is possible to combine this embodiment with the embodiment 1 and the embodiment 2.

### [Embodiment 4]

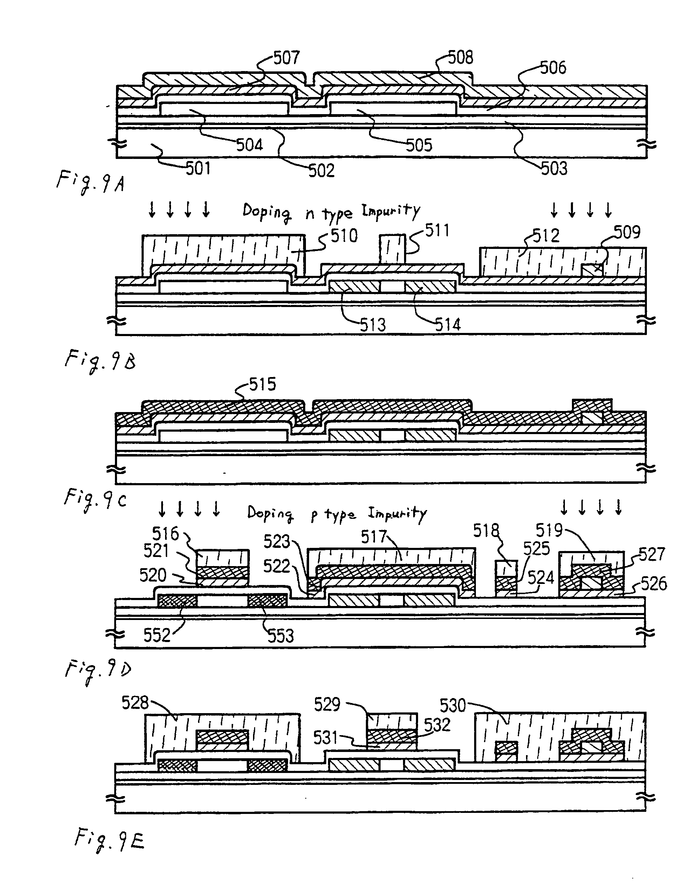

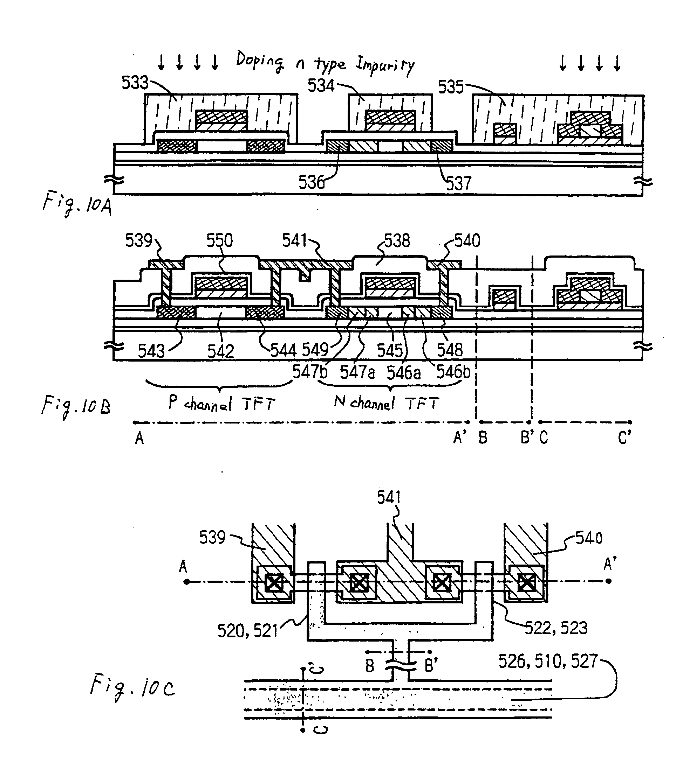

This embodiment will be described by referring to Figs. 9A to 9E and 10A to 10C. While in the embodiment 1 and embodiment 2 the silicon nitride film containing boron (SiBₓN_{y}) is used as one layer of the gate insulating film of the bottom gate TFT, this embodiment shows an example that a silicon nitride film containing boron (SiBₓN_{y}) is used as one layer of a base film (an underlying film) of a top gate TFT.

Here, we will explain about a case where an inverter circuit, which is a basic configuration of the CMOS circuit, is formed by manufacturing an n channel TFT and a p channel TFT on the same substrate.

A substrate 501 can be a glass substrate, a plastic substrate or a ceramic substrate. It is also possible to use a silicon substrate with an insulating film such as silicon oxide film and silicon nitride film formed on the surface of the silicon substrate. A metal substrate represented by stainless steel can be used. A quartz substrate can also be used.

On the principal surface of the substrate 501 where TFTs are to be formed, a base film 502 made of silicon nitride film containing boron (SiBₓN_{y}) and a base film 503 made of silicon oxynitride film are formed. In this embodiment, the silicon nitride film (SiBₓN_{y}) 502 is formed by sputtering a target of single crystal silicon in an atmosphere comprising argon (Ar) and diborane (B₂H₆₎. The silicon nitride film (SiBₓN_{y}) may also be formed by sputtering a target of single crystal silicon doped with boron in an atmosphere containing nitrogen (N₂) or ammonia (NH₃). The silicon nitride film (SiBₓN_{y}) 502 thus obtained has a high thermal conductivity because it includes 0.1-50 atoms% or 1-50 atoms%, preferably 0.1-10 atoms%, of boron and thus can prevent characteristic degradation due to heat of the semiconductor device. The base film 503 may be formed by the plasma CVD method or sputtering method and is provided in order to prevent impurities detrimental to TFT from diffusing into the semiconductor layer. A good result was obtained when the base film 502 made of silicon nitride film containing boron (SiBₓN_{y}) was formed to a thickness of 20-100 nm, typically 50 nm, and the base film 503 made of silicon oxynitride film was formed on the base film 502 to a thickness of 50-500 nm, typically 150-200 nm.

Although it is possible to choose either the base film 502 made of silicon nitride film containing boron (SiBₓN_{y}) or the base film 503 made of silicon oxynitride film in forming the base film, it has been found that the two-layer structure is most desirable considering the reliability of TFT.

The semiconductor layer formed in contact with the base film 503 should desirably be formed of a crystalline semiconductor that is obtained by crystallizing an amorphous semiconductor by a laser crystallization method or a solid phase crystallization using a heat treatment. The amorphous semiconductor is formed by the film deposition methods such as plasma CVD, low pressure CVD or sputtering. It is also possible to apply a microcrystalline semiconductor formed by the film deposition methods described above. The semiconductor materials that can be applied here include silicon (Si), germanium (Ge), silicon-germanium alloy and silicon carbide, and a compound semiconductor material such as gallium arsenide.

The semiconductor layer is formed to a thickness of 10-100 nm, typically 50 nm. The amorphous semiconductor film formed by the plasma CVD method contains 10-40 atoms% of hydrogen. It is desirable that, prior to the crystallization process, a heat treatment at 400-500°C is performed to release hydrogen and reduce the hydrogen content down to 5 atoms% or less. Although the amorphous silicon film may be formed by other methods such as sputtering or evaporation, it is desired that the impurity elements such as oxygen and nitrogen contained in the film are reduced sufficiently.

Because the base film and the amorphous semiconductor film can be formed by the same deposition method, the base film 503 and the semiconductor layer should preferably be formed continuously. After these films are formed, their surfaces are kept from exposing to open air in order to avoid contamination. This eliminated one of the factors contributing to characteristic variations of TFT.

The process of crystallizing the amorphous semiconductor film may use a known laser crystallization technique or a thermal crystallization technique. Forming a crystal semiconductor film by the thermal crystallization technique using a catalytic element can produce an excellent TFT characteristic.

The crystal semiconductor film thus formed is patterned by a known technique using a first photo mask to form a resist mask, and then island semiconductor layers 504, 505 are formed by dry etching.

On the surface of the island semiconductor layers 504, 505 is formed a gate insulating film 506 made mainly of silicon oxide or silicon nitride. It is also possible to use a silicon nitride film containing boron (SiBₓN_{y}) as the gate insulating film 506 to form a structure that prevents characteristic degradation due to heat of the semiconductor device. The gate insulating film 506 can be formed by the plasma CVD or sputtering to a thickness of 10-200 nm, preferably 50-150 nm.

On the surface of the gate insulating film 506 are formed a first conductive layer 507 and a third conductive layer 508. The first conductive layer 507 uses a conductive material made mainly of a selected element of Ta, Ti, Mo or W, and is formed to a thickness of 5-50 nm, preferably 10-25 nm.

The thickness of the gate insulating film 506 and the thickness of the first conductive layer 507 are important. Because, in a first impurity doping process to be carried out later, an impurity that gives an n type conductivity is added to the semiconductor layers 504, 505 through the gate insulating film 506 and the first conductive layer 507. The conditions of the first impurity doping process were actually determined considering the thickness of the gate insulating film 506 and the thickness of the first conductive layer 507. This is because variation of the thickness of the gate insulating film 506 and the thickness of the first conductive layer 507 from the predetermined values by 10% or more will reduce the concentration of the impurity being doped.

The second conductive layer 508 uses a conductive material made mainly of Al or Cu. When Al is used, for example, it is possible to use an Al alloy containing 0.1-5 atoms% of an element selected from Ti, Si and Sc. The second conductive layer needs to be formed to a thickness of 100-1000 nm, preferably 200-400 nm. The second conductive layer is provided as a wiring material to reduce the wire resistance of the gate line or gate bus line (Fig. 9A).

In this invention, the gate line is formed on the gate insulating film 506 and is made of the same material as the gate electrode to which it is connected. A gate bus line is also regarded as a part of the gate line.

Next, using a second photo mask, a resist mask is formed and unwanted parts of the third conductive layer are removed to form a part of the gate bus line 509 (Fig. 9B). When the second conductive layer is Al, it is found that the wet etching using a phosphoric acid solution is able to remove the third conductive layer with good selectivity from the underlying first conductive layer.

Then, by using a third photo mask, a resist mask 510 covering the semiconductor layer 504 and a resist mask 511 covering the channel forming region of the semiconductor layer 505 are formed. At this time, a resist mask 512 may also be formed on a region where the gate line and the gate bus line are to be formed.

Then, the process of adding a first impurity element which gives an n type conductivity is performed. The known impurity elements that give the n type conductivity to the crystalline semiconductor material include phosphorus (P), arsenic (As) and antimony (Sb). Here, phosphorus was used and an ion doping using phosphine (PH₃) was performed. In this process because phosphorus is implanted through the gate insulating film 506 and the first conductive layer 507 into the underlying semiconductor layer, the acceleration voltage was set at a somewhat high level of 80 kV. The concentration of phosphorus to be added to the semiconductor layer is preferably set in the range of 1x10¹⁶ to 1x10¹⁹ atoms/cm³. Here it was set at 1x10¹⁸ atoms/cm³. A part of the region doped with phosphorus forms a second impurity region that functions as an LDD region (Fig. 9B).

Then, the resist masks 510, 511, 512 are removed and a third conductive layer 515 is formed on the entire surface. The third conductive layer 515 may be formed of the same material as the first conductive layer 507 and is made mainly of an element selected from Ta, Ti, Mo and W. The thickness of the third conductive layer 515 is set in the range of 100-1000 nm, preferably 200-500 nm (Fig. 9C).

Then, by using a fourth photo mask, resist masks 516, 517, 518, 519 are formed. The fourth photo mask is used to form the gate electrode, gate line and gate bus line of the p channel TFT. Because the gate electrode of the n channel TFT is formed in a later process, the resist mask 517 is formed so that a portion of the first conductive layer 522 and a portion of the third conductive layer 523 remain on the semiconductor layer 505.

Unwanted portions of the first and third conductive layers are removed by dry etching. Then, gate electrodes 520, 521, gate lines 524, 525, and gate bus lines 526, 527 are formed.

The gate bus lines have a clad structure in which the second conductive layer 509 is covered by the first conductive layer 526 and the second conductive layer 527. The third conductive layer is made of a low-resistance material, mainly Al and Cu, and can reduce the resistance of wire.

Then, with the resist masks 516, 517, 518, 519 left as they are, a part of the semiconductor layer 504 where a p channel TFT is to be formed is doped with a third impurity element which gives a p type conductivity. The known impurity elements that will give the p type conductivity include boron (B) and gallium (Ga). Here, boron was used as the impurity element and the ion doping was performed using diborane (B₂H₆). The acceleration voltage was set at 80 kV and the boron was doped to a concentration of 2x10²⁰ atoms/cm³. Then, as shown in Fig. 9D, third impurity regions 552, 553 were formed where boron was highly concentrated.

After the resist masks formed in Fig. 9D are removed, a fifth photo mask is used to form resist masks 528, 529, 530. The fifth photo mask is used to form gate electrodes 531, 532 of the n channel TFT by dry etching. The gate electrodes 531, 532 are formed in such a way as to overlap a part of the second impurity regions 513, 514.

After the resist masks 528, 529, 530 are completely removed, resist masks 533, 534, 535 are formed. The resist mask 534 is formed to cover the gate electrodes 531, 532 of the n channel TFT and a part of the second impurity region. The resist mask 534 determines the offset of the LDD region.

A process of adding a second impurity element that gives an n type conductivity is performed. A first impurity region 537 serving as a source region and a first impurity region 536 serving as a drain region are formed. Here, ion doping was performed using phosphine. In this process, too, because phosphorus is implanted through the gate insulating film 506 into the underlying semiconductor layer, the acceleration voltage was set at a somewhat high level of 80 kV. The phosphorus concentration in these regions should preferably be set at 1x10¹⁹ to 1x10²¹ atoms/cm³, which is higher than when a first impurity element that gives an n type conductivity was doped. Here it was set at 1x10²⁰ atoms/cm³ (Fig. 10A).

Then, on the gate insulating film 506, gate electrodes 520, 521, 531, 532, gate lines 524, 525 and gate bus lines 526, 527 are formed first interlayer insulating films 538, 550. The first interlayer insulating film 550 is a silicon nitride film 50 nm thick, and the first interlayer insulating film 538 is a silicon oxide film 950 nm thick. The first interlayer insulating film 550 may use a silicon nitride film containing boron (SiBₓN_{y}) to provide a structure that prevents characteristic degradation due to heat of the semiconductor device.

The first interlayer insulating film 550 formed of the silicon nitride film is necessary for the next heat treatment process. This is found effective for preventing the surfaces of the gate electrodes 520, 521, 531, 532, gate lines 524, 525, and gate bus lines 526,527 from being oxidized.

The heat treatment process is necessary to activate the impurity elements doped in respective concentrations that give an n type or p type conductivity. This process may be carried out by a thermal anneal method using an electric furnace, a laser anneal method using the excimer laser, or a rapid thermal anneal method (RTA method) using a halogen lamp. The laser anneal method, though it can activate the impurity element at a low substrate heating temperature, is found to have difficulty in activating the impurity in areas hidden by the gate electrodes. Hence, the thermal anneal method was used for activation. The heating process is done in the nitrogen atmosphere at 300-700°C, preferably 350-550°C. Here it was performed at 450°C for 2 hours.

Then, the first interlayer insulating films 538, 550 are covered with a predetermined resist mask by using a seventh photo mask and etched to form contact holes reaching the source region and the drain region of each TFT. Then, source electrodes 539, 540 and a drain electrode 541 are formed. In this embodiment these electrodes are formed in a three-layer structure, though not shown, that consists of a Ti film 100 nm thick, an Al film containing Ti 300 nm thick and a Ti film 150 nm thick, all formed continuously by sputtering.

With the above processes completed, a channel forming region 545, first impurity regions 548, 549, and second impurity regions 546, 547 are formed. The second impurity regions have GOLD regions 546a, 547a that overlap the gate electrodes 531, 532 and LDD regions 546b, 547b that do not overlap the gate electrodes. The first impurity region 548 becomes a source region and the first impurity region 549 a drain region.

In the p channel TFT, on other hand, a channel forming region 542 and third impurity regions 543, 544 are formed. The third impurity region 543 becomes a source region and the third impurity region 544 a drain region (Fig. 10B).

Fig. 10C represents a top view of the inverter circuit, and a cross-sectional structure along the line A-A' of the TFT portion, a cross-sectional structure along the line B-B' of the gate line portion, and a cross sectional structure along the line C-C' of the gate bus line portion correspond to those indicated by the same reference symbols. In this invention, the gate electrodes and the gate lines are formed of the first conductive layer and the third conductive layer, and the gate bus lines have a clad structure consisting of the first conductive layer, the second conductive layer and the third conductive layer.

While Figs. 9A to 9E and 10A to 10C show a CMOS circuit as comprising the n channel TFT and the p channel TFT combined in a complementary manner, this invention can also be applied to an NMOS circuit using the n channel TFT and to a pixel matrix circuit of a liquid crystal display.

### [Embodiment 5]

This embodiment describes an example case in which the crystalline semiconductor film, that was used as the semiconductor layers 504, 505 in the embodiment 4, is formed by a thermal crystallization method using a catalytic element. When a catalytic element is used, a technique disclosed in JP-A 7-130652 and JP-A 8-78329 official gazettes should preferably be used. The JP-A 7-130652 corresponds to a U.S. Patent No. 5,643,826 and a U.S. Patent No. 5,923,962.

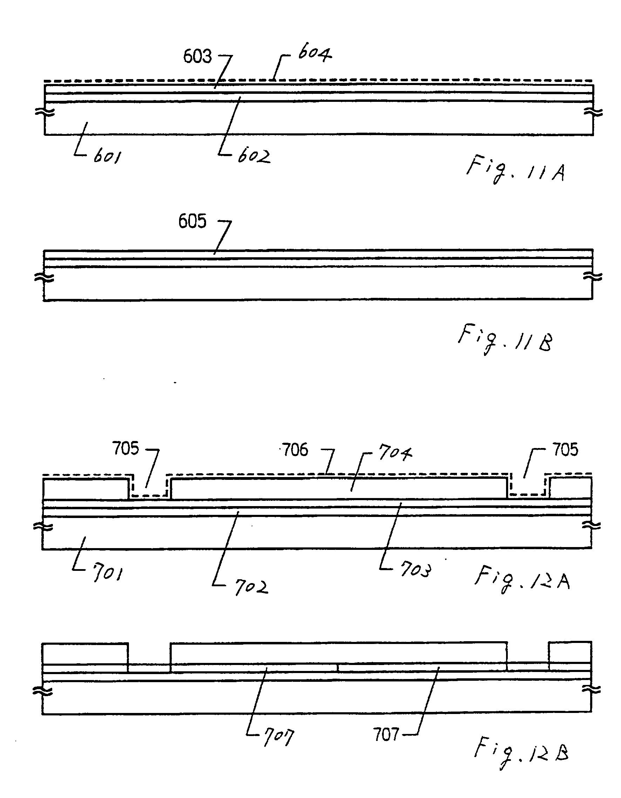

An example in which the technology disclosed in JP-A 7-130652 is applied to this invention is shown in Figs. 11A and 11B. First, a base film 602 is prepared on a substrate 601 and an amorphous silicon film 603 is formed on the base film. In this embodiment, the base film 602 has an upper layer of silicon oxide film and a lower layer of silicon nitride film containing boron (SiBₓN_{y}) in order to prevent characteristic degradation due to heat of the semiconductor device. If film flaking does not occur, the amorphous silicon film may be formed in contact with the silicon nitride film (SiBₓN_{y}). Further, 10 ppm by weight of nickel acetate solution containing nickel is applied to the amorphous silicon film to form a nickel-containing layer 604 (Fig. 11A).

Next, the wafer is heated at 500°C for 1 hour for dehydration followed by heat treatment at 500-650°C for 4-24 hours (in this embodiment 550°C for 14 hours) to form a polycrystalline silicon film 605. The polycrystalline silicon film 605 thus formed has an excellent crystallinity (Fig. 11B).

The technology disclosed in JP-A 8-78329 enables selective crystallization of an amorphous silicon film by selectively adding a catalytic element. An example of applying this technology to the present invention will be explained by referring to Figs. 12A and 12B.

First, a base film 702 is provided on a glass substrate 701 and then an amorphous silicon film 703 and a silicon oxide film 704 are successively formed on the base film. The base film 702 uses a silicon oxide film as its upper layer and a silicon nitride film containing boron (SiBₓN_{y}) as its lower layer in order to prevent characteristic degradation due to heat of the semiconductor device. If film peeling does not occur, the amorphous silicon film may be formed in contact with the silicon nitride film (SiBₓN_{y}).

Next, the silicon oxide film 704 is patterned to selectively form openings 705 and then 10 ppm by weight of nickel acetate solution containing nickel is applied to the wafer surface to form a nickel-containing layer 706, which contacts the amorphous silicon film 703 only at the bottom of the openings 705 (Fig. 12A).

Then, the wafer is heated at 500-650°C for 4-24 hours (in this embodiment, at 580°C for 14 hours) to form a polycrystalline silicon film 707. During this crystallization the portions of the amorphous silicon film contacted by nickel is first crystallized. From these portions the crystallization propagates horizontally. The polycrystalline silicon film 707 thus formed consists of aggregated bar or needle like crystals each of which grows in a particular orientation when macroscopically viewed. The polycrystalline silicon film 707 therefore has an advantage of aligned crystallinity.

In addition to nickel (Ni), catalytic elements that can be used with the above two technologies include germanium (Ge), iron (Fe), palladium (Pd), tin (Sn), lead (Pb), cobalt (Co), platinum (Pt), copper (Cu) and gold (Au).

The semiconductor layers of TFT can be formed by forming a crystalline semiconductor film (including polycrystalline silicon film and crystalline silicon-germanium film) and patterning this film according to the above-described technologies. The TFTs manufactured from the crystalline semiconductor film by using the technology of this embodiment has excellent characteristics but are required to offer a high level of reliability. With the insulating films and the TFT structure of this invention, however, it is possible to fabricate the TFTs taking full advantage of the technology of this embodiment.

### [Embodiment 6]

This embodiment describes an example case in which the process of forming the semiconductor layers 504, 505 used in the embodiment 4 involves first forming a crystalline semiconductor film from an amorphous semiconductor film as an initial film by using a catalytic element as in the embodiment 5, and then removing the catalytic element from the crystalline semiconductor film. This embodiment uses a technology disclosed in JP-A 10-135468 or JP-A 10-135469 official gazettes for this method. The JP-A 10-135468 and the JP-A 10-135469 correspond to a U.S. Patent Application Serial No. 08/951,193 and a U.S. Patent Application Serial No. 08/951,819, respectively (corresponding respectively to later-published patents US 6590230 and US 6365933).

The technology disclosed in the official gazette is the one that removes the catalytic element used for crystallization of the amorphous silicon film by using the gettering action of phosphorus after the crystallization is finished. The use of this technology enables reduction of the concentration of the catalytic element in the crystal semiconductor film down to 1x10¹⁷ atoms/cm³ or less, preferably to 1x10¹⁶ atoms/cm³.

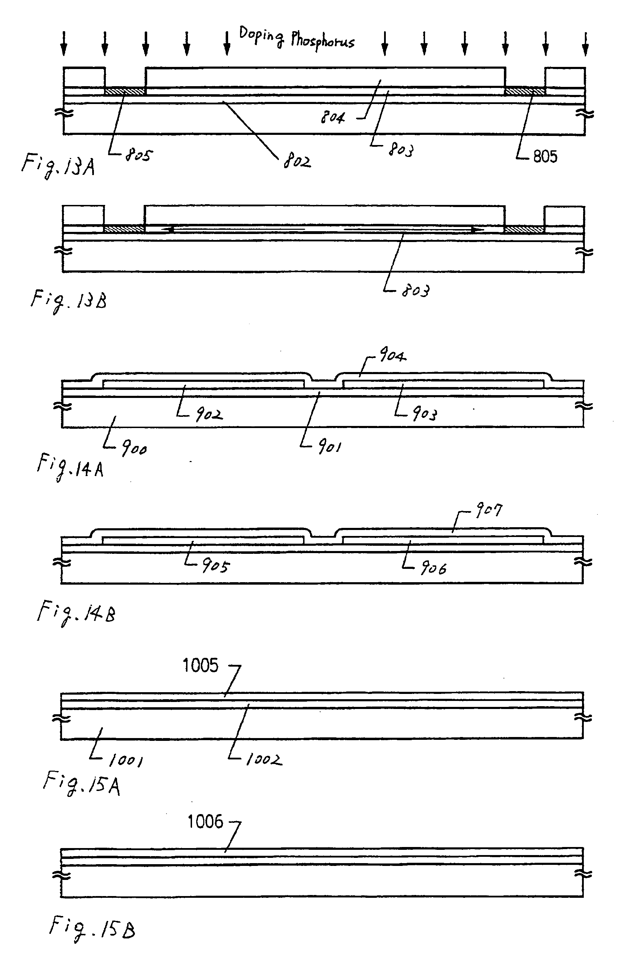

The construction of this embodiment will be explained by referring to Figs. 13A and 13B. Here, an alkali-free glass substrate represented by the Corning 1737 substrate is used. Fig. 13A shows a base film 802 and a polycrystalline silicon film 803 formed by using the crystallization technique of the embodiment 2. In this embodiment, the base film 802 uses a silicon oxynitride film as its upper layer and a silicon nitride film containing boron (SiBₓN_{y}) as its lower layer in order to prevent characteristic degradation due to heat of the semiconductor device. If film flaking does not occur, the amorphous silicon film may be formed in contact with the silicon nitride film (SiBₓN_{y}). Then, a silicon oxide film 804 for masking is formed on the surface of the polycrystalline silicon film 803 to a thickness of 150 nm and is patterned to form openings therein to expose the polycrystalline silicon film. Then, phosphorus is doped to form phosphorus-doped regions 805 in the polycrystalline silicon film.

In this state, the wafer is heated at 550-800°C for 5-24 hours (in this embodiment, at 600°C for 12 hours) in a nitrogen atmosphere. As a result, the phosphorus-doped regions 805 in the polycrystalline silicon film acted as gettering sites and caused the catalytic element remaining in the polycrystalline silicon film 803 to move into the phosphorus-doped regions 805.

Then, the silicon oxide film 804 for masking and the phosphorus-doped regions 805 are etched away to obtain a polycrystalline silicon film in which the concentration of the catalytic element used in the crystallization process has reduced to below 1x10¹⁷ atoms/cm³. The polycrystalline silicon film thus obtained was able to be used as is for the semiconductor layers of TFT shown in the embodiment 4.

### [Embodiment 7]

This embodiment shows another example of forming the semiconductor layers 504, 505 and the gate insulating film 506 during the process, shown in the embodiment 4, of manufacturing the TFT of this invention.

A substrate with heat resistance of at least 700-1100° C is required and a quartz substrate 900 was used. A base film 901 uses a silicon oxide film as its upper layer and silicon nitride film containing boron (SiBₓN_{y}) as its lower layer to prevent characteristic degradation due to heat of the semiconductor device. If film peeling does not occur, the amorphous silicon film may be formed in contact with the silicon nitride film (SiBₓN_{y}). Then, the crystalline semiconductor film is formed by using the technology shown in the embodiment 5. To make it active layers of TFT, the crystal semiconductor film is then patterned in islands to form semiconductor layers 902, 903. Then, a gate insulating film 904 mainly of silicon oxide is formed on the semiconductor layers 902, 903. In this embodiment, a silicon oxynitride film was formed by the plasma CVD method to a thickness of 70 nm (Fig. 14A).

Then the heat treatment is performed, in this embodiment, at 950°C for 30 minutes in an atmosphere containing halogen (typically chlorine) and oxygen. It has been found that a satisfactory result can be obtained if the processing temperature is selected in a range of 700-1100°C and the processing time in a range between 10 minutes and 8 hours (Fig. 14B).

As a result, under the conditions of this embodiment, a thermal oxide film, i.e., gate insulating film 907, is formed at the interface between the semiconductor layers 902, 903 and the gate insulating film 904.

The gate insulating film 907 formed in the above process has a high dielectric strength, and the interface between the semiconductor layers 905, 906 and the gate insulating film 907 was very good. The subsequent processes can be carried out according to the embodiment 4 to manufacture the TFT.

The implementer can appropriately combine the embodiment 5 or embodiment 6 with this embodiment as required.

### [Embodiment 8]

This embodiment describes an example of manufacturing a polycrystalline silicon film in a process different from that of the embodiment 4. In more detail, this embodiment explains about a gettering process different from the one shown in the embodiment 5. The basic process conforms to Figs. 9A to 9E or Figs. 10A to 10C and thus only the difference will be explained.

The state of Fig. 15A is obtained by following the process of the embodiment 5. A polycrystalline silicon film 1005 that constitutes an active layer of TFT is formed by using the thermal crystallization technique shown in the embodiment 5.

Next, the whole substrate 1101 is immersed in a liquid (in this embodiment, sulfuric acid solution) heated to 300° C to remove or reduce the nickel content used for crystallization. While this embodiment performs the gettering prior to patterning the active layer, the gettering may be done after the patterning of the active layer. A method of dropping a heated sulfuric acid solution uniformly on the substrate maybe usedas anothermeans of bringing the substrate into contact with sulfuric acid.

In this process, nickel dissolves in the heated sulfuric acid and is easily removed from around the surface. Then, nickel remaining inside diffuses toward the surface area where the nickel concentration is low, from which it is dissolved away. As this phenomenon is repeated, nickel used for crystallization is removed from the polycrystalline silicon film or its content reduced. With the catalytic element reduction process involving a liquid performed in this way, the concentration of the catalytic element in the polycrystalline silicon film 1006 can be lowered to 1x10¹⁷ atoms/cm³, preferably 1x10¹⁶ atoms/cm³ (Fig. 15B).

To enhance the contact between the sulfuric acid solution and the crystalline semiconductor film, it is preferred that a naturally oxidized film on the surface of the crystalline semiconductor film be cleared in advance by an etchant including hydrofluoric acid. This enhances the gettering efficiency.

While this embodiment takes up nickel as an example, other catalytic elements can also be removed by the similar phenomenon of gettering.

The polycrystalline silicon film 1006 thus obtained is then subjected to the process explained in the embodiment 5 to manufacture the TFT shown in Figs. 10A to 10C.

This embodiment can be combined with any of the preceding embodiments 4 through 7 arbitrarily.

### [Embodiment 9]

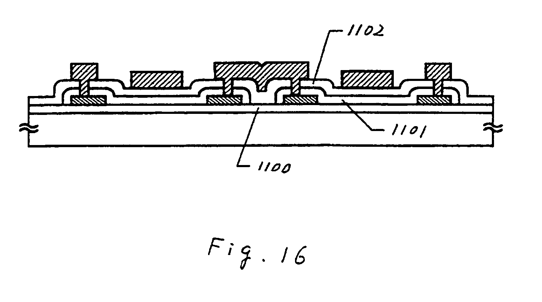

In the embodiment 1, we have shown a case where an insulating film (SiBₓN_{y}) containing 0.1-50 atoms% or 1-50 atoms%, preferably 0.1-10 atoms%, of boron and having a high thermal conductivity is used as one layer of the gate insulating film of a bottom gate TFT. With reference to Fig. 16, this embodiment explains an example case in which a boron-containing silicon nitride film (SiBₓN_{y}) according to this invention is applied to the insulating film used in a staggered TFT.

Fig. 16 shows a representative staggered TFT. First, a source layer and a drain layer are formed on a substrate that is already formed with a base film 1100. Then, an amorphous silicon film is formed covering the source layer and the drain layer and is crystallized by a laser beam to form a semiconductor layer 1101. Then, an insulating film is formed, followed by the formation of gate electrodes and interconnects, to manufacture a staggered TFT. In this embodiment, the silicon nitride film containing boron (SiBₓN_{y}) is applied to the base film 1100 or insulating film 1102.

In this way, this invention can be applied regardless of the TFT structure.

### [Embodiment 10]

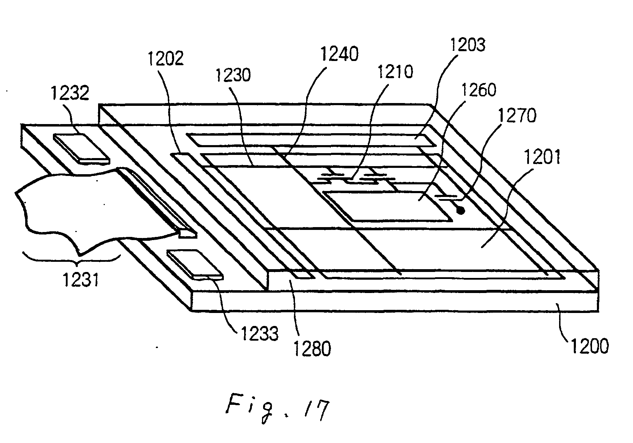

This embodiment describes, with reference to Fig. 17, an example of a liquid crystal display manufactured according to this invention. The method of fabricating the pixel TFT (pixel switching element) and the cell assembly process can be performed by using known means, so their detailed descriptions are omitted.

Fig. 17 is a schematic diagram of an active matrix liquid crystal panel of this embodiment. As shown in Fig. 17, the active matrix substrate and a counter substrate are opposed to each other with a liquid crystal material sandwiched between these substrates. The active matrix substrate has a pixel matrix circuit 1201, a scanning line drive circuit 1202, and a signal line drive circuit 1203.

The scanning line drive circuit 1202 and the signal line drive circuit 1203 are connected to the pixel matrix circuit 1201 through scanning lines 1230 and signal lines 1240. These drive circuits 1202, 1203 are constructed mainly of CMOS circuits.

A scanning line 1230 is formed for each row of the pixel matrix circuits 1201, and a signal line 1240 is formed for each column of the pixel matrix circuits 1201. Near the intersection between the scanning line 1230 and the signal line 1240, a pixel TFT 1210 is formed. The pixel TFT 1210 has its gate electrode connected to the scanning line 1230 and its source connected to the signal line 1240. Further, a drain of the pixel TFT 1210 is connected to a pixel electrode 1260 and a storage capacitance 1270.

The counter substrate 1280 has a transparent conductive film such as ITO film formed on the entire glass substrate. The transparent conductive film is a counter electrode opposing the pixel electrode 1260 of the pixel matrix circuit 1201, and the liquid crystal material is driven by an electric field generated between the pixel electrode and the counter electrode. The counter substrate 1280 is formed with an orientation film, a black matrix and a color filter, as required.

The glass substrate on the active matrix substrate side is mounted with IC chips 1232, 1233 at the surface to which an FPC 1231 is attached. These IC chips 1232, 1233 have a video signal processing circuit, a timing pulse generation circuit, a γ correction circuit, a memory circuit and a calculation circuit, all integrated on a silicon substrate.

While this embodiment describes the liquid crystal display as an example, it is of course possible to apply this invention to EL (electroluminescence) displays and EC (electrochromic) displays as long as they are active matrix displays.

The liquid crystal display that can be manufactured by this invention can be of a transmission type or a reflection type, whichever the implementer may choose. In this way, this invention can be applied to any type of active matrix electro optical device (semiconductor device).

In manufacturing the semiconductor device shown in this embodiment, any configuration of the embodiment 1 through embodiment 9 may be adopted or this embodiment may be combined with these preceding embodiments arbitrarily.

### [Embodiment 11]

This invention can be applied to the conventional IC technologies in general, that is, to all semiconductor circuits currently available in the market. For example, it may be applied to microprocessors, such as RISC processors or ASIC processors integrated on a single chip, and to high frequency circuits for signal processing circuits and mobile equipments (cellular phone, PHS, and mobile computer) represented by liquid crystal driver circuits (D/A converter, γ correction circuit, signal division circuit, etc.).

Further, it is also possible to realize a three-dimensional semiconductor device by forming an interlayer insulating film on a conventional MOSFET and, according to this invention, forming a semiconductor circuit on the interlayer insulating film. In this way this invention can be applied to all semiconductor devices incorporating LSI currently available. For example, this invention may be applied to the SOI structures (TFT structures using single crystal semiconductor thin films), such as SIMOX, Smart-Cut (trade name of SOITEC), and ELTRAN (trade name of Canon).

Semiconductor circuits such as microprocessors are incorporated in electronic apparatus and function as a central circuit. Representative electronic apparatus include personal computers, mobile information terminals, and various other electric appliances. Control computers for vehicles (automobiles and trains) are also an example of such electronic apparatus. This invention can also be applied to these semiconductor devices.

In manufacturing the semiconductor devices described in this embodiment, any configuration of the embodiment 1 through embodiment 9 may be adopted or this embodiment may be combined with these preceding embodiments in any way.

### [Embodiment 12]

While the embodiment 1 has described a case where a polycrystalline silicon film is used as the TFT active layer, this embodiment uses an amorphous silicon film as an active layer.

The boron-containing insulating film according to this invention is more suited for the amorphous silicon TFT using an amorphous silicon film as an active layer than for the polycrystalline silicon TFT using a crystalline silicon film as an active layer.

According to the embodiment 1. gate electrodes are formed on the substrate.

Next, on the gate electrodes are continuously formed a gate insulating film and an amorphous silicon film. In the case of the amorphous silicon TFT, although the gate insulating film may be formed in a multiple layer as in the embodiment 1, this embodiment successively formed a silicon nitride film containing boron and an amorphous silicon film in the same chamber because the active layer of amorphous silicon, even when mixed with boron, does not become active and the conductivity type is not affected.

Next, as in the embodiment 1, an insulating film (a channel protection film) that protects the channel forming region is formed on the amorphous semiconductor film. This insulating film may also be formed continuously with the amorphous silicon film.

These processes, when finished, complete a bottom gate TFT as shown in Fig. 3C of the embodiment 1.

While this embodiment has shown a case where this invention is applied to one layer of the gate insulating film of the bottom gate TFT, the invention can also be applied to other types of insulating film, which include a base film, an interlayer insulating film, a mask insulating film, a channel protection film and a passivation film.

For example, if the gate insulating film is formed of a silicon nitride film containing boron and the channel protection film is formed of a silicon nitride film containing boron, with the channel forming region sandwiched between the silicon nitride films containing boron, an effective heat dissipation structure can be obtained. It is also possible to use a silicon nitride film containing boron as the gate insulating film and a silicon oxynitride film (SiNₓB_{y}O_{z}: X, Y and Z are values representing composition ratios; X>0, Y>0, Z>0) containing boron as the channel protection film. Alternatively, it is possible to use a silicon nitride film as the gate insulating film and a silicon oxynitride film (SiNₓB_{y}O_{z}) containing boron as the channel protection film.

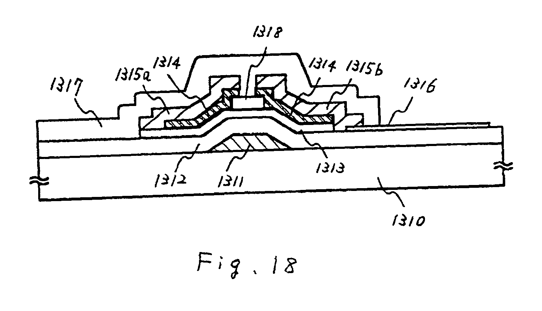

The bottom gate TFT using amorphous silicon generally has a structure as shown in Fig. 18. This structure, too, can of course apply the silicon nitride film containing boron according to this invention.

In Fig. 18, reference number 1310 represents a substrate 1311 a gate electrode, 1312 a gate insulating film, 1313 a semiconductor region made of amorphous silicon, 1314 a semiconductor region doped with an impurity element (phosphorus or boron) that gives a p type or n type conductivity, 1315a a source electrode, 1315b a drain electrode, 1316 a pixel electrode, 1317 an interlayer insulating film, and 1318 a channel protection film. This invention can be applied to the insulating films shown in Fig. 18, for example, the gate insulating film 1312, the interlayer insulating film 1317 and the channel protection film 1318.

Further, when a silicon nitride film containing boron is used for the gate insulating film 1312 and for the channel protection film 1318, because the semiconductor region 1313 is sandwiched between the silicon nitride films containing boron, heat can be dissipated efficiently. The silicon nitride film containing boron may be replaced with a silicon oxynitride film containing boron.

In manufacturing the semiconductor device shown in this embodiment, any configuration of the embodiment 1 through embodiment 3 can be adopted or the semiconductor device of this embodiment can be combined with the embodiments 10 and 11.

### [Embodiment 13]

The CMOS circuits and the pixel circuits formed according to this invention can be applied to a variety of electro optical apparatus (active matrix liquid crystal display, active matrix EL display, and active matrix EC display). In other words, this invention can be implemented in all electronic equipment incorporating the electro optical apparatus into the displays.

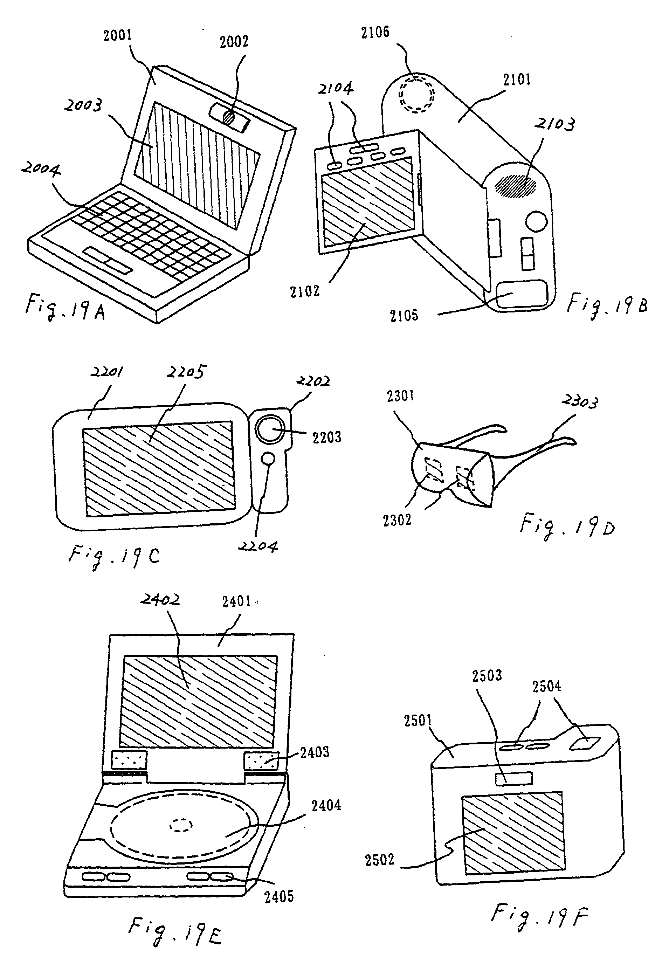

Among such electronic equipment are video cameras, digital cameras, projectors (rear type or front type), head-mounted displays (goggle type displays), car navigation equipment, car stereos, personal computers, portable information terminals (mobile computers, cellular phones or electronic books). Examples of these equipments are shown in Figs. 19A to 19F, 20A to 20D and 21A to 21C.

Fig. 19A shows a personal computer, which includes a body 2001, an image input portion 2002, a display 2003, and a keyboard 2004. This invention can be applied to the image input portion 2002, display 2003 and other signal control circuits.

Fig. 19B shows a video camera, which includes a body 2101, a display 2102, a voice input portion 2103, an operation switch 2104, a battery 2105, and image receiving portion 2106. This invention can be applied to the display 2102 and other signal control circuits.

Fig. 19C shows a mobile computer which includes a body 2201, a camera portion 2202, an image receiving portion 2203, an operation switch 2204, and a display 2205. This invention can be applied to the display 2205 and other signal control circuits.

Fig. 19D shows a goggle type display, which includes a body 2301, a display 2302, and an arm portion 2303. This invention can be applied to the display 2302 and other signal control circuits.

Fig. 19E shows a player for a recording medium storing a program, which includes a body 2401, a display 2402, a speaker 2403, a recording medium 2404, and operation switch 2405. This player uses DVD (digital versatile disc) as a recording medium and CD (compact disc) for playing music, movie and game and accessing the Internet. This invention can be applied to the display 2402 and other signal control circuits.

Fig. 19F shows a digital camera, which includes a body 2501, a display 2502, an eye piece 2503, an operation switch 2504, and an image receiving portion (not shown). This invention can be applied to the display 2502 and other signal control circuits.

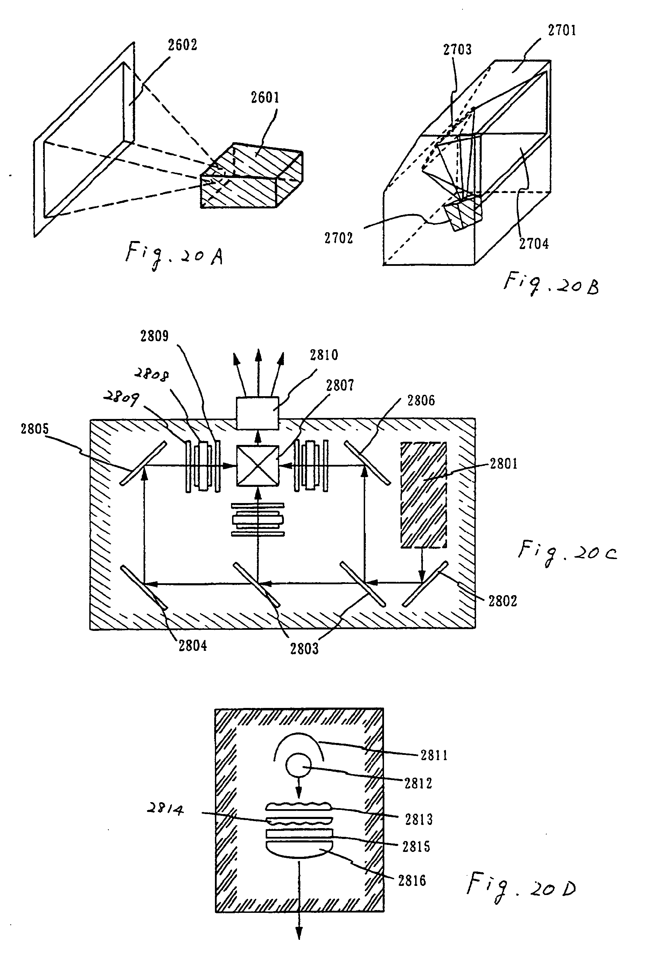

Fig. 20A shows a front type projector, which includes a projection device 2601 and a screen 2602. This invention can be applied to a liquid crystal display 2808 that constitutes a part of the projection device 2601, and other signal control circuits.

Fig. 20B shows a rear type projector, which includes a body 2701, a projection device 2702, a mirror 2703, and a screen 2704. This invention can be applied to a liquid crystal display 2808 that constitutes a part of the projection device 2702, and other signal control circuits.

Fig. 20C shows an example structure of the projection devices 2601, 2702inFigs. 20A and 20B. The projection devices 2601, 2702 comprise a light source optical system 2801, mirrors 2802, 2804, 2805 and 2806, dichroic mirror 2803, prism 2807, liquid crystal display 2808, phase plate 2809, and projection optical system 2810. The projection optical system 2810 includes projection lenses. Although the projection optical system in this embodiment is shown to be of three-plate type, it may be of single plate type. On the light paths indicated by the arrows in Fig. 20C, the implementer may install an optical system, such as an optical lens, a polarizing film, a phase difference adjusting film and an IR film.

Fig. 20D shows an example structure of the light source optical system 2801 in Fig. 20C. In this embodiment, the light source optical system 2801 comprises a reflector 2811, a light source 2812, lens arrays 2813, 2814, a polarization transducer 2815, a focusing lens 2816. The light source optical system shown in Fig. 20D is only one example and not limiting in any way. For example, the implementer may provide an optical lens, a polarizing film, a phase difference adjust film and an IR film in the light source optical system as required.

Fig. 20, however, represents an example case where the projector uses the electro optical apparatus of a transmission type, and not a reflection type electro optical apparatus or EL display.

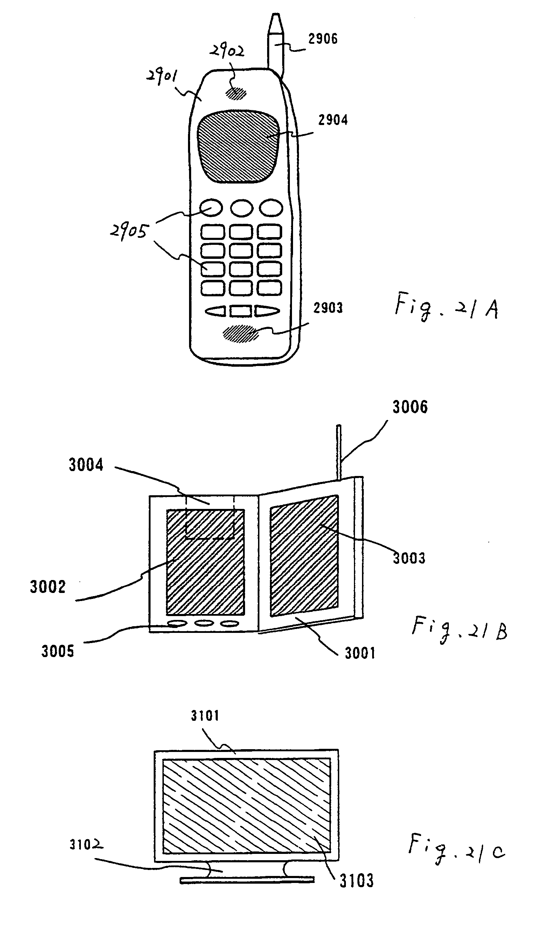

Fig. 21A shows a cellular phone, which includes a body 2901, a voice output portion 2902, a voice input portion 2903, a display 2904, an operation switch 2905, and an antenna 2906. This invention can be applied to the voice output portion 2902, the voice input portion 2903, the display 2904 and other signal control circuits.

Fig. 21B shows a portable book (electronic book), which includes a body 3001, displays 3002, 3003, a recording medium 3004, an operation switch 3005 and an antenna 3006. This invention can be applied to the displays 3002, 3003 and other signal control circuits.

Fig. 21C shows a display device including a body 3101, amount 3102 and a display 3103. This invention can be applied to the display 3103. The display device of this invention is particularly advantageous when it is increased in size, for instance, to a diagonal size of 10 inches or greater particularly 30 inches or more.

As described above, the range of application of this invention is very wide and can include every field of electronic apparatus.

In manufacturing the semiconductor device shown in this embodiment, any configuration of the embodiments 1 through 9 and embodiment 12 can be adopted and this embodiment can be combined with any of these preceding embodiments. The electro optical apparatus and semiconductor circuits of the embodiment 10 and 11 may also be combined with this embodiment.

### [Embodiment 14]

This embodiment describes a case where the invention is applied to the manufacture of an EL (electroluminescence) display.

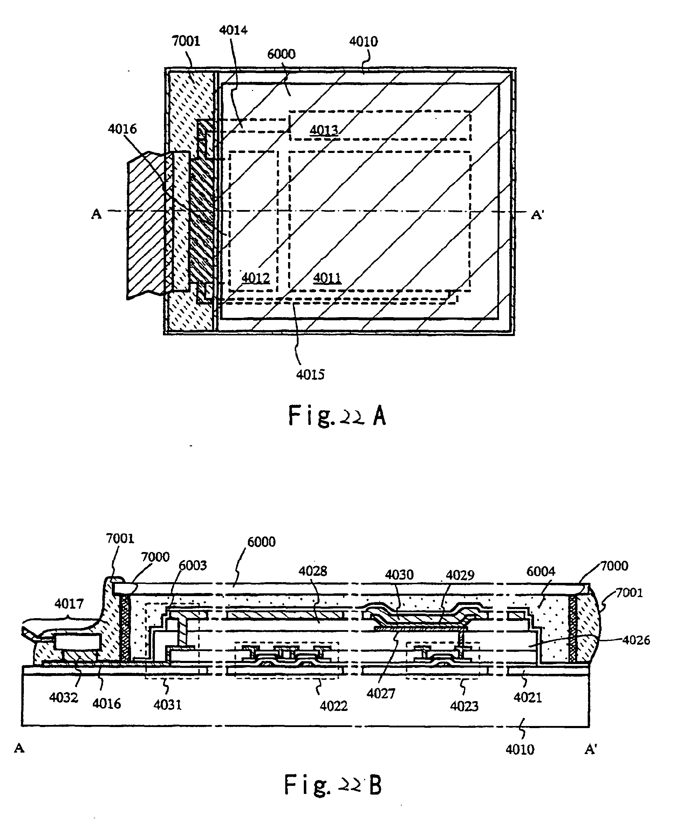

Fig. 22A is a top view of the EL display applying the invention. In Fig. 22A, reference numeral 4010 represents a substrate, 4011 a pixel portion, 4012 a source side drive circuit, and 4013 a gate side drive circuit. These drive circuits are connected through lines 4014-4016 to an FPC 4017, from which they are connected to an external device.

A cover member 6000, a sealing material (or housing material) 7000 and a sealant (or second sealing material) 7001 are arranged to enclose at least the pixel portion, preferably the drive circuit and the pixel portion.

Fig. 22B is a cross section of the EL display of this embodiment. On the substrate 4010 and the base film 4021 are formed a drive circuit TFT (here a CMOS circuit combining an n channel TFT and a p channel TFT is shown) 4022 and a pixel portion TFT 4023 (here only a TFT for controlling the current to the EL element is shown). These TFTs can be formed in a known structure (a top-gate structure or a bottom-gate structure).

This invention can be applied to the manufacture of the drive circuit TFT 4022 and the pixel portion TFT 4023.

With the drive circuit TFT 4022 and the pixel portion TFT 4023 completed according to this invention, a pixel electrode 4027 of a transparent conductive film electrically connected to a drain of the pixel portion TFT 4023 is formed on an interlayer insulating film (a flattening film) 4026 made of a resin material. When the pixel electrode 4027 is a transparent conductive film, the pixel portion TFT should preferably be a p channel TFT. The transparent conductive film can use a compound of indium oxide and tin oxide (called ITO) or a compound of indium oxide and zinc oxide. Then an insulating film 4028 is formed on the pixel electrode 4027 and an opening is formed in the insulating film 4028 above the pixel electrode 4027.

Next, an EL layer 4029 is formed. The EL layer 4029 may have a laminated layer structure or a single-layer structure, in which known EL materials (hole injection layer, hole transport layer, light emitting layer, electron transport layer or electron injection layer) are combined as desired. Any desired structure can be formed according to known technologies. Among the EL materials are a low-molecule material and a high-molecule (polymer) material. When a low-molecule material is used, an evaporation method is used. When a high-molecule material is used, simple methods such as a spin coating method, a printing method or an ink jet method can be employed.

In this embodiment a shadow mask is used and the EL layer is formed by evaporation. By using the shadow mask to form light emitting layers capable of emitting light of different wavelengths for individual pixels (red light emitting layer, green light emitting layer and blue light emitting layer), a color display can be realized. Other methods include a method combining the color conversion layer and a color filter and a method combining a white light emitting layer and a color filter. Either of these methods may be used. It is of course possible to provide an EL display that emits a monochromatic radiation.

On the EL layer 4029 is formed a cathode 4030. It is desired that water and oxygen present on the interface between the cathode 4030 and the EL layer 4029 be removed as practically as possible. For this purpose, the EL layer 4029 and the cathode 4030 should be formed continuously in vacuum. Alternatively, the EL layer 4029 should be formed in an inert atmosphere and, without exposing it to an open air, the cathode 4030 subsequently formed. In this embodiment, a film forming apparatus based on a multi chamber method (cluster tool method) is used to meet the above requirements.

This embodiment uses a laminated structure of LiF (lithium fluoride) film and Al (aluminum) film as the cathode 4030. It is fabricated by forming a LiF (lithium fluoride) film to a thickness of 1 nm on the EL layer 4029 and then forming an aluminum film to a thickness of 300 nm on the LiF film. A MgAg electrode, a known cathode material, may of course be used. Then, the cathode 4030 is connected to a line 4016 in an area indicated by 4031. The line 4016 is a power supply line to give a predetermined voltage to the cathode 4030 and is connected to the FPC 4017 through a conductive paste material 4032.

To electrically connect the cathode 4030 and the line 4016 in the region indicated by 4031, contact holes must be formed in the interlayer insulating film 4026 and the insulating film 4028. These contact holes may be formed during the etching of the interlayer insulating film 4026 (when forming contact holes for pixel electrodes) and during the etching of the insulating film 4028 (when forming openings prior to the formation of the EL layer). When etching the insulating film 4028, it may be etched to the interlayer insulating film 4026 at one time. In that case, if the interlayer insulating film 4026 and the insulating film 4028 are made of the same resin material, the contact holes can be formed in good condition.

A passivation film 6003, a filler 6004 and a cover member 6000 are formed on the surface of the EL element thus formed.

Further, the sealing material is provided on the inside of the cover member 6000 and the substrate 4010, surrounding the EL element portion. On the outside of the sealing material a sealant (second sealing material) 7001 is formed.

The filler 6004 works as a bonding agent for holding the cover member 6000. The filler 6004 may use PVC (polyvinyl chloride), epoxy resin, silicone resin, PVB (polyvinyl butyral) or EVA (ethylene vinyl acetate). A desiccant should preferably be provided in the filler 6004 to absorb moisture.

A spacer may be mixed in the filler 6004. The spacer may be formed as grains or particles made of BaO to give the spacer itself a moisture absorbing capability.

When the spacer is used, the passivation film 6003 can alleviate the spacer pressure. Apart from the passivation film a resin film may be used to alleviate the spacer pressure.

Materials for the cover member 6000 include glass plate, aluminum plate, stainless steel plate, FRP (fiberglass-reinforced plastics) plate, PVF (polyvinyl fluoride) film, Mylar film, polyester film or acrylic film. When PVB or EVA is used as the filler 6004, a sheet should preferably be used which has an aluminum foil several tens of micrometers thick held between PVF films or Mylar films.

Depending on the direction of light emission from the EL element (direction of light radiation), the cover member 6000 may need to have a light transmitting capability.

The line 4016 is electrically connected to the FPC 4017 through a gap between the sealing material 7000 and sealant 7001 and the substrate 4010. Other lines 4014, 4015 are electrically connected to the FPC 4017 in the similar manner, running under the sealing material 7000 and sealant 7001.

### [Embodiment 15]

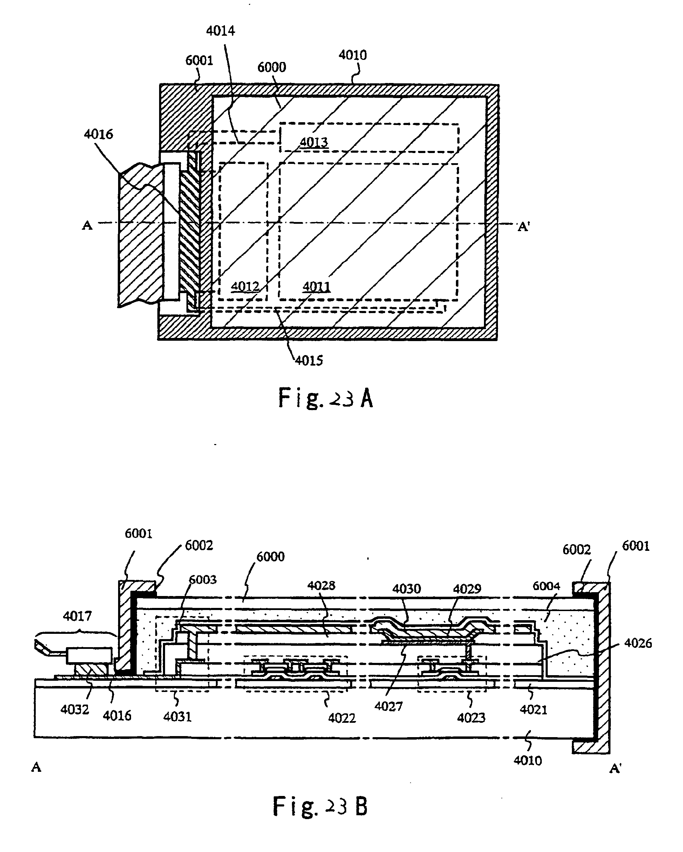

Referring to Figs. 23A and 23B, this embodiment explains the manufacture of an EL display implemented according to this invention which is different from that of the embodiment 14. The same reference numbers as those in Figs. 22A and 22B represent the identical components and their explanations are omitted.

Fig. 23A is a top view of the EL display of this embodiment and Fig. 23B is a cross section taken along the line A-A' of Fig. 23A.

The display is formed up to a passivation film 6003 that covers the surface of the EL element, according to the procedure of the embodiment 14.

Then, a filler 6004 is arranged to cover the EL element. The filler 6004 may use PVC (polyvinyl chloride), epoxy resin, silicone resin, PVB (polyvinyl butyral) or EVA (ethylene vinyl acetate). A desiccant should preferably be provided in the filler 6004 to absorb moisture.

A spacer may be mixed in the filler 6004. The spacer may be formed as grains or particles made of BaO to give the spacer itself a moisture absorbing capability.

When the spacer is used, the passivation film 6003 can alleviate the spacer pressure. Apart from the passivation film a resin film may be used to alleviate the spacer pressure.

Materials for the cover member 6000 include glass plate, aluminum plate, stainless steel plate, FRP (fiberglass-reinforced plastics) plate, PVF (polyvinyl fluoride) film, Mylar film, polyester film or acrylic film. When PVB or EVA is used as the filler 6004, a sheet should preferably be used which has an aluminum foil several tens of micrometers thick held between PVF films or Mylar films.

Depending on the direction of light emission from the EL element (direction of light radiation), the cover member 6000 may need to have a light transmitting capability.

After the cover member 6000 is bonded by using the filler 6004, frame members 6001 are mounted to cover the side surfaces (exposed surface) of the filler 6004. The frame members 6001 are bonded by the sealing material 6002 which works as a bonding agent. The sealing material 6002 should preferably use a photosetting resin but, if the EL layer has sufficient heat resistance, a thermosetting resin may be used. The sealing material 6002 should preferably be a material not pervious to water and oxygen. A desiccant may be added in the sealing material 6002.

The line 4016 is electrically connected to the FPC 4017 through a gap between the sealing material 6002 and the substrate 4010. Other lines 4014, 4015 are electrically connected to the FPC 4017 in the similar manner, running under the sealing material 6002.

### [Embodiment 16]

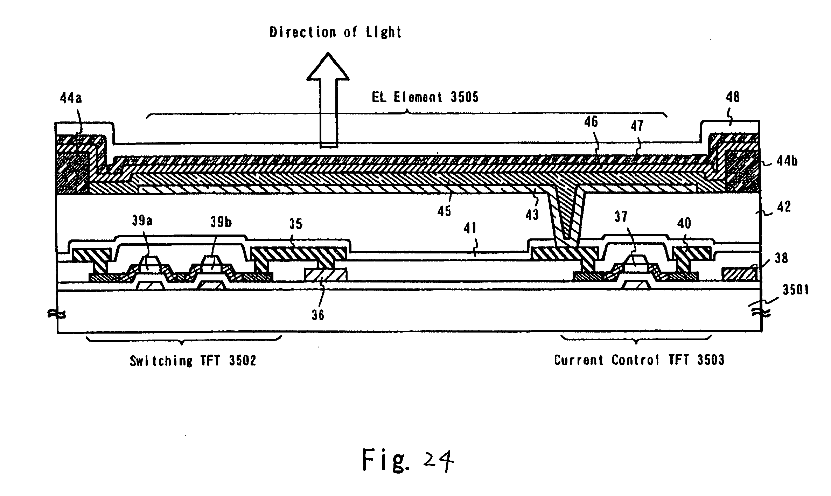

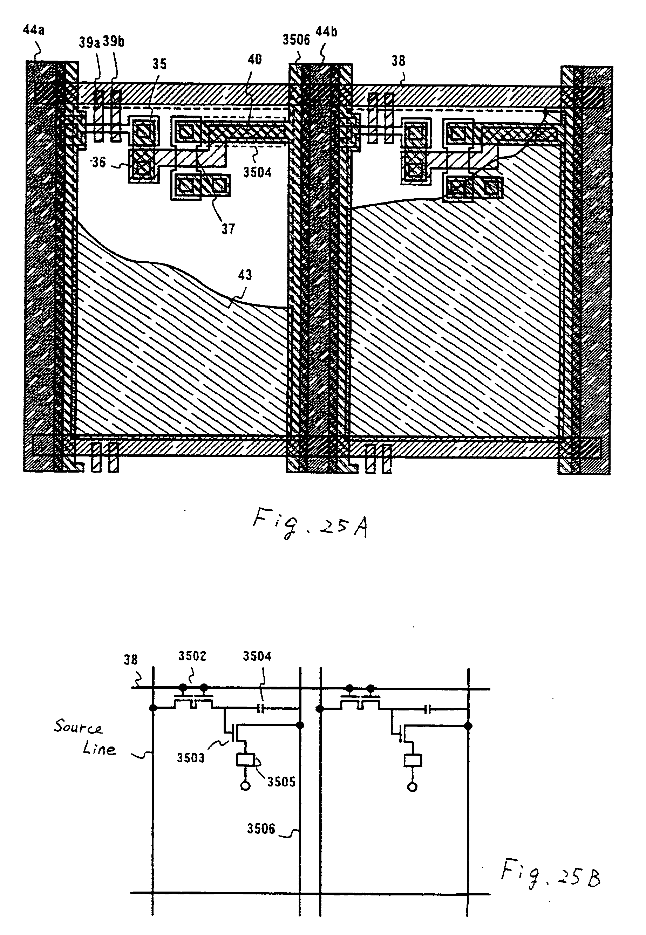

This embodiment shows a detailed cross-sectional structure of the pixel portion of the EL display in Fig. 24, a top-view structure in Fig. 25A and a circuitry in Fig. 25B. Figs. 24, 25A and 25B use common reference numbers.

In Fig. 24, a switching TFT 3502 on the substrate 3501 is formed by using the N channel TFT of this invention (see the embodiments 1 through 12). Although it is formed in a double gate structure in this embodiment, there is no large difference in the structure and the manufacturing process and thus its explanation is omitted. It should be noted, however, that the double gate structure allows two TFTs to be virtually connected in series, reducing the off-state current. While this embodiment employs the double gate structure, it is possible to use a single gate structure, a triple gate structure or a multigate structure having four or more gates. It is also possible to use the PTFT of this invention.

The current control TFT 3503 is formed by using the N channel TFT of this invention. The drain wire 35 of the switching TFT 3502 is electrically connected to the gate electrode 37 of the current control TFT through the line 36. The line indicated by 38 is a gate line for electrically connecting the gate electrodes 39a and 39b of the switching TFT 3502.

The fact that the current control TFT 3503 has the structure of this invention has a very important significance. The current control TFT controls the current flowing through the EL element and carries a large current and therefore has a high level of possibility of degradation due to heat and hot carriers. For this reason, the structure of this invention, in which an LDD region is formed to overlap the gate electrode through the gate insulating film on the drain side of the current control TFT, is very effective.

While this embodiment shows the current control TFT 3503 in the single gate structure, it may be formed in a multi gate structure in which a plurality of TFTs are connected in series. Further, it may be constructed to have a structure in which a plurality of TFTs are connected in parallel and the channel forming region is divided in two or more regions to enable heat dissipation with an improved efficiency. Such a structure is effective as a measure against thermal deterioration.

As shown in Fig. 25A, the wire forming the gate electrode 37 of the current control TFT 3503 overlaps the drain wire 40 of the current control TFT 3503 through the insulating film in a region indicated by 3504. In the region 3504 a capacitance is formed. The capacitance 3504 works to retain a voltage being applied to the gate of the current control TFT 3503. The drain wire 40 is connected to the current supply line (power supply line) 3506 and applied a constant voltage at all times.

On the switching TFT 3502 and the current control TFT 3503 is formed a first passivation film 41, on which a flattening film 42 of resin insulating film is formed. Flattening steps formed by the TFTs by using the flattening film 42 is very important. Because the EL layer to be formed later is very thin, the presence of a step may cause a failure of radiation. Hence, it is desired that the plane underlying the EL layer be formed as flat as possible prior to forming the pixel electrode so that the EL layer can be formed flat.

Denoted 43 is a pixel electrode (cathode of EL element) formed of a conductive film with high reflectivity, which is electrically connected to the drain of the current control TFT 3503. In this case, an n channel TFT should preferably be used for the current control TFT. The pixel electrode 43 should preferably use low resistance conductive films or their laminated films, such as aluminum alloy film, copper alloy film or silver alloy film. A laminated structure using other conductive films may also be used.

In a recess (corresponding to a pixel) formed by banks 44a, 44b made of an insulating film (preferably resin) is formed a light emitting layer 45. Although only one pixel is shown here, light emitting layers corresponding to red (R), green (G) and blue (B) may also be formed separately. A π conjugated polymer material is used as an organic EL material for the light emitting layer. Typical polymer materials include poly-para-phenylenevinylene (PPV), polyvinylcarbazole (PVK) and (polyfluorene).

Many kinds of PPV-based organic EL materials are available. Among them are materials disclosed in "Polymers for Light Emitting Diodes, by "H. Schenk, H. Becker, O. Gelsen, E. Kluge, W. Kreuder, and H. Spreitzer, Euro Displays, Proceedings, 1999, pp.33-37" and JP-A 10-92576 official gazette.

In more specific terms, the red, green and blue light emitting layers may use cyanopolyphenylenevinylene, polyphenylenevinylene, and polyalkylphenylene, respectively. Their thickness may be set to 30-150 nm (preferably 40-100 nm).

These are only examples of the organic EL material that can be used as the light emitting layers and there is no need to limit the material to the above examples. The light emitting layers, charge transport layers or charge injection layers can be combined arbitrarily to form the EL layer (a layer for emitting light and for moving carriers for radiation).

While this embodiment has described an example of the light emitting layer using a polymer material, a low molecule organic EL material may be used. It is also possible to use an inorganic material such as silicon carbide for the charge transport layer and the charge injection layer. These organic EL materials and inorganic materials may be chosen from known materials.

In this embodiment, the EL layer is formed on the light emitting layer 45 in a laminated layer structure having a hole injection layer 46 made of a PEDOT (polythiophene) or PAni (polyaniline). On the hole injection layer 46 is formed an anode 47 made of a transparent conductive film. In this embodiment, light generated from the light emitting layer 45 is radiated upward (upward of TFT), so that the anode must be able to transmit light. The transparent conductive film may be made from a compound of indium oxide and tin oxide and from a compound of indium oxide and zinc oxide. Because the transparent conductive film is formed after the light emitting layer and the hole injection layer with low heat resistance are formed, it should preferably be formed at as low a temperature as possible.

With the anode 47 formed, the EL element 3505 is complete. The EL element 3505 represents a capacitor comprising the pixel electrode (cathode) 43, light emitting layer 45, hole injection layer 46 and anode 47. The pixel electrode 43 almost coincides with an area of the pixel as shown in Fig. 25A, so the pixel as a whole functions as the EL element.

In this embodiment, a second passivation film 48 is formed on the anode 47. The second passivation film 48 should preferably be formed of a silicon nitride film or a silicon oxynitride film. The purpose of this passivation film is to isolate the EL element from the outside, which in turn prevents degradation due to oxidation of the organic EL material and minimizes the amount of gas escaping from the organic EL material. As a result, the reliability of the EL display can be enhanced.

As described above, the EL display panel of this invention has a pixel portion having a pixel with a structure as shown in Fig. 24, and also includes a switching TFT with a sufficiently low off-state current value and a current control TFT with high tolerance for hot carrier injection. The EL display panel therefore has high reliability and can produce an image of good quality.

The configuration of this embodiment can be realized by combining the embodiments 1 through 12 arbitrarily. The EL display panel of this embodiment can be effectively employed for the display of the electronic apparatus of the embodiment 13.

### [Embodiment 17]

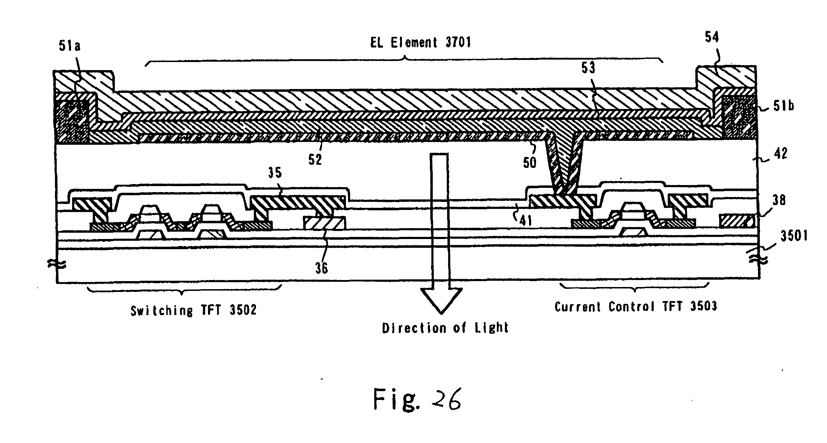

This embodiment explains, with reference to Fig. 26, about the structure in which the EL element 3505 in the pixel portion of the embodiment 16 is inverted. The only point in which this embodiment differs from the structure of Fig. 24 is the EL element and the current control TFT, and thus explanation of other components are omitted.

In Fig. 26, the current control TFT 3503 is formed by using the P channel TFT of this invention. The embodiments 1 through 12 should be referenced for the manufacturing process.

In this embodiment, a transparent conductive film is used for the pixel electrode (anode) 50. More specifically, the conductive film used is made of a compound of indium oxide and zinc oxide. A conductive film made of a compound of indium oxide and tin oxide may also be used.

After banks 51a, 51b of insulating film are formed, a light emitting layer 52 of polyvinylcarbazole is formed by applying a solution. On this layer are formed an electronic injection layer 53 of potassiumacetylacetonate (denoted as acacK) and a cathode 54 of aluminum alloy. The cathode 54 functions as a passivation film. In this way the EL element 3701 is formed.

The light generated from the light emitting layer 52 is radiated toward the substrate where TFT is formed, as indicated by arrow.

The configuration of this embodiment can be realized by combining the embodiments 1 through 12 arbitrarily. The EL display panel of this embodiment can effectively be used for the display of the electronic apparatus of the embodiment 13.

### [Embodiment 18]

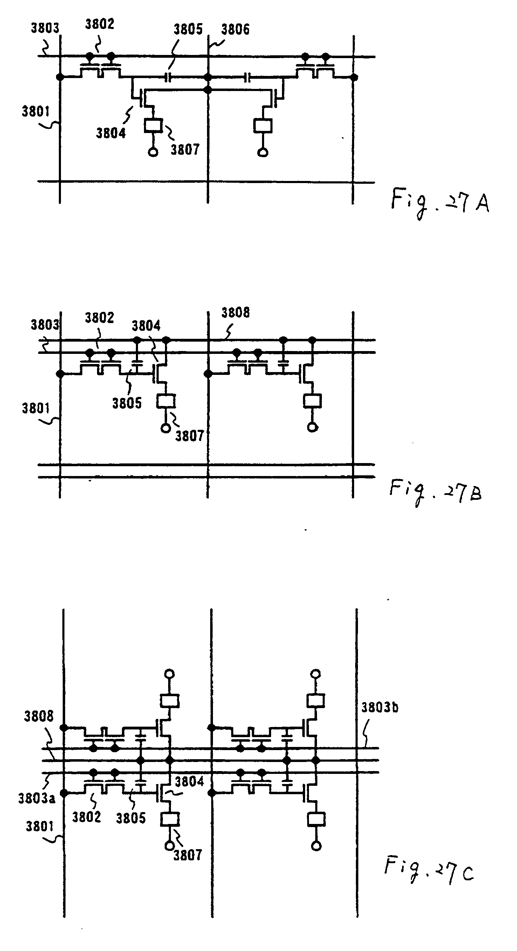

This embodiment shows in Figs 27A to 27C pixels with structures different from the circuitry of Fig. 25B. In this embodiment, denoted 3801 is a source line for the switching TFT 3802; 3803 a gate line for the switching TFT 3802; 3804 a current control TFT; 3805 a capacitor; 3806 and 3808 current supply lines; and 3807 an EL element.

Fig. 27A represents a case where the current supply line 3806 is used commonly by two pixels. This is characterized in that two pixels are formed axially symmetric with respect to the current supply line 3806. This configuration can reduce the number of power supply lines and therefore enhance the resolution of the pixel portion.

Fig. 27B represents a case where the current supply line 3808 is provided parallel to the gate line 3803. Although in Fig. 27B the current supply line 3808 and the gate line 3803 are arranged not to overlap each other, if they are formed on different layers, they may overlap each other through an insulating film. In this case, because the power supply line 3808 and the gate line 3803 can share their occupied areas, the resolution of the pixel portion can be enhanced.

Fig. 27C is characterized in that the current supply line 3808 is arranged parallel to the gate lines as in the structure of Fig. 27B and that two pixels are arranged axially symmetric with respect to the current supply line 3808. It is also possible to arrange the current supply line 3808 to overlap either one of the gate lines 3803. This configuration can reduce the number of power supply lines and therefore further improve the resolution of the pixel portion.

The configuration of this embodiment can be realized by combining the embodiments 1 through 12, 14 and 15 arbitrarily. The EL display panel of this embodiment can effectively be used for the display of the electronic apparatus of the embodiment 13.

### [Embodiment 19]

While in Figs. 25A and 25B representing the embodiment 16 the capacitor 3504 is provided to maintain a voltage being applied to the gate of the current control TFT 3503, it is possible to omit the capacitor 3504. In the case of the embodiment 16, because the NTFT of this invention as shown in the embodiments 1 through 12 is used for the current control TFT 3503, there is an LDD region that overlaps the gate electrode through the gate insulating film. In this overlapping region a parasitic capacitance generally called a gate capacitance is formed, and this embodiment is characterized in that this parasitic capacitance is positively used instead of the capacitor 3504.

The parasitic capacitance, because it changes according to the area of the overlapping region of the gate electrode and the LDD region, is determined by the length of the LDD region contained in the overlapping region.

As in the structures of the embodiment 18 shown in Figs. 27A, 27B and 27C, the capacitor 3805 can be omitted.

The configuration of this embodiment can be realized by combining the embodiments 1 through 12 and 14 through 18 arbitrarily. The EL display having the pixel structure of this embodiment can be effectively used for the display of the electronic apparatus of the embodiment 13.

As described above, the film made mainly of silicon nitride according to this invention contains 0.1-50 atoms% or 1-50 atoms%, preferably 0.1-10 atoms%, of boron, and thus has a high thermal conductivity, which in turn provides a capability of preventing characteristic degradation due to heat of the semiconductor device. Further, the film made mainly of silicon nitride according to the invention has a capability of blocking movable ions such as sodium and thus can prevent these ions from the substrate from infiltrating into the semiconductor device, particularly into the channel forming region.

With this invention, it is possible to enhance the reliability of the semiconductor device including CMOS circuits of TFTs, more specifically, the reliability of the pixel matrix circuits of the liquid crystal display and of the drive circuits provided around the pixel matrix circuits. The invention can also improve the reliability of the electronic apparatus incorporating as its components the semiconductor circuit including TFTs and the liquid crystal display.

## Claims

1. A semiconductor device comprising:
a gate electrode (102) formed on an insulating surface;
a gate insulating film (103a) formed on the gate electrode(102); and
a semiconductor film (104, 105) forming a source region (115), a drain region (116), and a channel forming region (119) between the source region (115) and the drain region (116), all these regions formed on and in contact with the gate insulating film (103a);
**characterized in that**
the gate insulating film (103a) has a layer of a silicon nitride film containing boron,
wherein the source region (115) and the drain region (116) comprise an impurity element that gives n type conductivity to the source region and the drain region.

2. A semiconductor device comprising:
a semiconductor film forming a source region, a drain region, and a channel forming region between the source region and the drain region, all these regions formed on and in contact with an insulating surface;
a gate insulating film formed on the channel forming region; and
a gate electrode formed on and in contact with the gate insulating film;
wherein the gate insulating film has one layer of a silicon nitride film containing boron, and
wherein the source region and the drain region comprise an impurity element that gives n type conductivity to the source region and the drain region.

3. A semiconductor device according to any one of claims 1 to 2, wherein the silicon nitride film contains 0.1 to 50 atoms% boron.

4. A semiconductor device according to any one of claims 1 to 2, wherein the silicon nitride film contains 0.1 to 10 atom% boron.

5. A semiconductor device according to any of claims 1 to 2, wherein the semiconductor device is an electro optical apparatus or an electronic apparatus.

6. A semiconductor device according to any one of claims 1 to 2, wherein the semiconductor device is an electro optical apparatus selected from a liquid crystal display, an EC display and an image sensor.

7. A semiconductor device according to any one of claims 1 to 2, wherein the semiconductor device is an EL display.

8. A semiconductor device according to any one of claims 1 to 2, wherein the semiconductor device is an electronic apparatus selected from a video camera, a digital camera, a projector, a goggle display, a car navigation, a personal computer and a portable information terminal.

9. The semiconductor device according to claim 1, further comprising:
an insulating layer (111a) comprising silicon nitride and boron on the semiconductor film (104, 105).

10. A semiconductor device according to claim 1, wherein the semiconductor film (104) comprises an amorphous silicon semiconductor.

11. A semiconductor device according to claim 1, wherein the semiconductor film (105) comprises a crystalline or a polycrystalline silicon semiconductor.

12. A semiconductor device according to claim1, wherein in the gate insulating film (1312) the silicon nitride film containing boron is replaced with a silicon oxynitride film containing boron on the gate electrode;
the semiconductor device further comprising a channel protection layer (1318) located between the source and drain regions comprising silicon oxynitride containing boron on a polysilicon semiconductor film.

13. A semiconductor device according to claim 2, wherein the impurity element that give n type conductivity comprises at least one of phosphorus (P), arsenic (As) and antimony (Sb).

14. A method of manufacturing a semiconductor device comprising the steps of:
forming a gate electrode (102) on an insulating surface; forming on the gate electrode (102) a gate insulating film (103a);
forming a semiconductor thin film (104, 105) on the gate insulating film (103a); and
**characterized by**
doping the semiconductor thin film(104, 105) with an impurity element that gives n type conductivity to the semiconductor thin film,
wherein the gate insulating film(103a) comprises a silicon nitride containing boron.

15. A method of manufacturing a semiconductor device comprising the steps of:
forming a semiconductor thin film on an insulating surface;
doping the semiconductor thin film with an impurity element that gives n type conductivity to the semiconductor thin film.
forming on the semiconductor thin film a gate insulating film comprising silicon nitride containing boron; and
forming a gate electrode on the gate insulating film.

16. A method of manufacturing a semiconductor device according to claim 15, wherein the impurity element that gives n type conductivity comprises at least one of phosphorus (P), arsenic (As) and antimony (Sb).

## Patentansprüche

1. Halbleitervorrichtung, die folgendes umfasst:
eine Gateelektrode (102), die auf eine isolierenden Oberfläche ausgebildet;
ein Gateisolationsfilm (103a), der auf der Gateelektrode (102) ausgebildet ist; und
ein Halbleiterfilm (104, 105), der einen Sourcebereich (115), einen Drainbereich (116) und einen kanalbildenden Bereich (119) zwischen dem Sourcebereich (115) und dem Drainbereich (116) bildet, wobei alle diese Bereiche auf und in Kontakt mit dem Gateisolationsfilm (103a) ausgebildet sind;
**dadurch gekennzeichnet, dass**
der Gateisolationsfilm (103a) eine Schicht aus Siliziumnitrid aufweist, der Bor enthält,
worin der Sourcebereich (115) und der Drainbereich (116) ein Verunreinigungselement umfasst, das dem Sourcebereich und dem Drainbereich n-Leitfähigkeit verleiht.

2. Halbleitervomchtung, die folgendes umfasst:
einen Halbleiterfilm, der einen Sourcebereich, einen Drainbereich und einen kanalbildenden Bereich zwischen dem Sourcebereich und dem Drainbereich bildet, wobei all diese Regionen auf und in Kontakt mit einer isolierenden Oberfläche ausgebildet sind;
einen Gateisolationsfilm, der auf dem kanalbildenden Bereich ausgebildet ist; und
eine Gateelektrode, die auf in und Kontakt mit dem Gateisolationsfilm ausgebildet ist;
worin der Gateisolationsfilm eine Schicht eines Siliziumnitridfilms aufweist, der Bor enthält, und
worin der Sourcebereich und der Drainbereich ein Verunreinigungselement umfasst, das dem Sourcebereich und dem Drainbereich n-Leitfähigkeit verleiht.

3. Halbleitervorrichtung nach einem der Ansprüche 1 bis 2, worin die Siliziumnitridschicht 0,1 bis 50 Atomprozent Bor enthält.

4. Halbleitervorrichtung nach einem der Ansprüche 1 bis 2, worin der Siliziumnitridfilm 0,1 bis 10 Atomprozent Bor enthält.

5. Halbleitervorrichtung nach einem der Ansprüche 1 bis 2, worin die Halbleitervorrichtung ein elektrooptisches Gerät oder ein elektronisches Gerät ist.

6. Halbleitervorrichtung nach einem der Ansprüche 1 bis 2, worin die Halbleitervorrichtung ein elektrooptisches Gerät ist, das aus dem Folgenden ausgewählt wird: eine Flüssigkeitskristallanzeige, eine EC-Anzeigevorrichtung und ein Bildsensor.

7. Halbleitervorrichtung nach einem der Ansprüche 1 bis 2, worin die Halbleitervorrichtung eine EL-Anzeigevorrichtung ist.

8. Halbleitervorrichtung nach einem der Ansprüche 1 bis 2, worin die Halbleitervorrichtung ein elektronisches Gerät ist, das aus dem Folgenden ausgewählt wird: eine Videokamera, eine Digitalkamera, ein Projektor, eine Brillenanzeigevorrichtung, eine Autonavigationsvorrichtung, ein Personalcomputer und ein portables Informationsdatenendgerät.

9. Halbleitervorrichtung nach Anspruch 1, die weiterhin umfasst:
eine Isolierschicht (111a), die Siliziumnitrid und Bor auf dem Halbleiterfilm (104, 105) umfasst.

10. Halbleitervorrichtung nach Anspruch 1, worin der Halbleiterfilm (104) einen amorphen Siliziumhalbleiter umfasst.

11. Halbleitervorrichtung nach Anspruch 1, worin der Halbleiterfilm (105) einen kristallinen oder einen polykristallinen Siliziumhalbleiter umfasst.

12. Halbleitervorrichtung nach Anspruch 1, worin in dem Gateisolationsfilm (1312) der Siliziumnitridfilm, der Bor enthält, durch einen Siliziumoxinitridfilm, der Bor enthält, auf der Gateelektrode ersetzt wird;
wobei die Halbleitervorrichtung weiterhin eine Kanalschutzschicht (1318) umfasst, die zwischen dem Source- und dem Drainbereich liegt, und die Siliziumoxinitrid umfasst, das Bor auf einem Polysiliziumhalbleitefilm enthält.

13. Halbleitervorrichtung nach Anspruch 2, worin das Verunreinigungselement, das n-Leitfähigkeit verleiht, zumindest eines der folgenden umfasst: Phosphor (P), Arsen (As) und Antimon (Sb).

14. Verfahren zur Herstellung einer Halbleitervorrichtung, das folgende Schritte umfasst:
Bilden einer Gateelektrode (102) auf einer isolierenden Oberfläche;
Bilden eines Gateisolationsfilms (103a) auf der Gateelektrode (102);
Bilden eines Halbleiterdünnfilms (104, 105) auf dem Gateisolationsfilm (103a); und
**gekennzeichnet durch**
Dotieren des Halbleiterdünnfilms (104, 105) mit einem Verunreinigungselement, das dem Halbleiterdünnfilm n-Leitfähigkeit verleiht,
wobei der Gateisolationsfilm (103a) ein Siliziumnitrid umfasst, das Bor enthält.

15. Verfahren zur Herstellung einer Halbleitervorrichtung, das folgenden Schritte umfasst:
Bilden eines Halbleiterdünnfilms auf einer isolierenden Oberfläche;
Dotieren des Halbleiterdünnfilms mit einem Verunreinigungselement, das dem Halbleiter dünnfilm n-Leitfähigkeit verleiht;
Bilden eines Gateisolationsfilms, der Siliziumnitrid umfasst, das Bor enthält, auf dem Halbleiterdünnfilm; und
Bilden einer Gateelektrode auf dem Gateisolationsfilm.

16. Verfahren zur Herstellung einer Halbleitervorrichtung nach Anspruch 15, worin das Verunreinigungselement, das n-Leitfähigkeit verleiht, zumindest eines der folgenden umfasst: Phosphor (P), Arsen (As) und Antimon (Sb).

## Revendications

1. Dispositif semi-conducteur comprenant :
une électrode de grille (102) formée sur une surface isolante ;
un film d'isolation de grille (103a) formé sur l'électrode de grille (102) ;
un film semi-conducteur (104, 105) formant une zone source (115), une zone drain (116) et une zone formant conduit (119) entre celles-ci, toutes ces zones étant formées sur le film d'isolation de grille (103a) et étant en contact avec celui-ci ;
**caractérisé en ce que** le film d'isolation de grille (103a) a une couche de film de nitrure de silicium contenant du bore,
la zone source (115) et la zone drain (116) comprenant un élément d'impureté qui donne une conductivité du type n à ladite zone source et à ladite zone drain.

2. Semi-conducteur comprenant :
un film semi-conducteur qui forme une zone source, une zone drain et une zone formant conduit entre celles-ci; toutes ces zones étant formées sur une surface isolante et étant en contact avec celle-ci ;
un film d'isolation de grille formé sur la zone formant conduit ; et
une électrode de grille formée sur le film d'isolation de grille et en contact avec celui-ci ;
le film d'isolation de grille ayant une couche de film de nitrure de silicium contenant du bore, et
la zone source et la zone drain comprenant un élément d'impureté qui donne une conductivité du type n à ladite zone source et à ladite zone drain.

3. Dispositif semi-conducteur selon l'une quelconque des revendications 1 à 2, dans lequel le film de nitrure de silicium contient 0,1 à 50 % en atomes de bore.

4. Dispositif semi-conducteur selon l'une quelconque des revendications 1 à 2, dans lequel le film de nitrure de silicium contient 0,1 à 10 % en atomes de bore.

5. Dispositif semi-conducteur selon l'une quelconque des revendications 1 à 2, le dispositif semi-conducteur étant constitué par un appareil électro-optique ou un appareil électronique.

6. Dispositif semi-conducteur selon l'une quelconque des revendications 1 à 2, le dispositif semi-conducteur étant constitué par un appareil électro-optique choisi parmi un affichage à cristaux liquides, un affichage EC et un capteur d'image.

7. Dispositif semi-conducteur selon l'une quelconque des revendications 1 à 2, le dispositif semi-conducteur étant constitué par un affichage EL.

8. Dispositif semi-conducteur selon l'une quelconque des revendications 1 à 2, le dispositif semi-conducteur étant constitué par un appareil électronique choisi parmi une caméra vidéo, une caméra numérique, un projecteur, un affichage pour lunette, un système de navigation pour automobile, un ordinateur individuel et un terminal d'information portable.

9. Dispositif semi-conducteur selon la revendication 1, comprenant également :
une couche isolante (111a) comprenant du nitrure de silicium et du bore sur le film semi-conducteur (104, 105).

10. Dispositif semi-conducteur selon la revendication 1, dans lequel le film semi-conducteur (104) comprend un semi-conducteur en silicium amorphe.

11. Dispositif semi-conducteur selon la revendication 1, dans lequel le film semi-conducteur (105) comprend un semi-conducteur à silicium cristallin ou polycristallin.

12. Dispositif semi-conducteur selon la revendication 1, dans lequel dans le film d'isolation de grille (1312) le film de nitrure de silicium contenant du bore est remplacé par un film d'oxynitrure de silicium contenant du bore sur l'électrode de grille, le dispositif semi-conducteur comprenant également une couche de protection de conduit (1318) située entre la zone source et la zone drain comprenant un oxynitrure de silicium contenant du bore sur un film semi-conducteur en polysilicium.

13. Dispositif semi-conducteur selon la revendication 2, dans lequel l'élément d'impureté qui donne une conductivité du type n comprend l'une au moins des substances suivantes : phosphore (P), arsenic (As) et antimoine (Sb).

14. Procédé pour fabriquer un dispositif semi-conducteur, comprenant les étapes qui consistent :
à former une électrode de grille (102) sur une surface isolante ;
à former sur l'électrode de grille (102) un film d'isolation de grille (103a) ;
à former un mince film semi-conducteur (104, 105) sur le film d'isolation de grille (103a) ; et
**caractérisé par** le dopage du mince film semi-conducteur (104, 105) avec un élément d'impureté, qui lui donne une conductivité du type n,
le film d'isolation de grille (103a) comprenant un nitrure de silicium contenant du bore.

15. Procédé pour fabriquer un dispositif semi-conducteur comprenant les étapes qui consistent :
à former un mince film semi-conducteur sur une surface isolante ;
à doper le mince film semi-conducteur avec un élément d'impureté qui donne à celui-ci une conductivité du type n,
à former sur le mince film semi-conducteur un film d'isolation de grille qui comprend un nitrure de silicium contenant du bore ;
et à former une électrode de grille sur le film d'isolation de grille.

16. Procédé pour fabriquer un dispositif semi-conducteur selon la revendication 15, selon lequel l'élément d'impureté qui donne une conductivité du type n comprend l'une au moins des substances suivantes :
phosphore (P), arsenic (As) et antimoine (Sb).
